# EUROPEAN PATENT SPECIFICATION

(11) **EP 3 951 416 B1**
(45) Date of publication and mention of the grant of the patent: **02.10.2024**
(21) Application number: 20189555.4
(22) Date of filing: 05.08.2020
(51) Int. Cl.: G01R 33/34, G01N 24/08, G01R 33/30

(54) **DEVICE AND METHOD FOR PERFORMING NMR SPECTROSCOPY**
VORRICHTUNG UND VERFAHREN ZUR DURCHFÜHRUNG EINER NMR-SPEKTROSKOPIE
DISPOSITIF ET PROCÉDÉ POUR RÉALISER UNE SPECTROSCOPIE RMN

(43) Date of publication of application: 09.02.2022
(73) Proprietor: Karlsruher Institut für Technologie, 76131 Karlsruhe (DE)
(72) Inventor: DAVOODI, Hossein, 76133 Karlsruhe (DE); BADILITA, Vlad, 67160 Weiler (FR); KORVINK, Jan G., 76228 Karlsruhe (DE)
(74) Representative: Müller-Boré & Partner Patentanwälte PartG mbB

(56) References cited:
- US-A1- 2002 190 715
- ZHAO EVAN WENBO ET AL: "In situ NMR metrology reveals reaction mechanisms in redox flow batteries", NATURE, MACMILLAN JOURNALS LTD, LONDON, vol. 579, no. 7798, 2 March 2020 (2020-03-02), pages 224 - 228, XP037060262, ISSN: 0028-0836, [retrieved on 20200302], DOI: 10.1038/S41586-020-2081-7
- WENCONG LIU ET AL: "Application of Surface Coil for Nuclear Magnetic Resonance Studies of Semi-conducting Thin Films", ARXIV.ORG, CORNELL UNIVERSITY LIBRARY, 201 OLIN LIBRARY CORNELL UNIVERSITY ITHACA, NY 14853, 18 October 2017 (2017-10-18), XP081296261, DOI: 10.1063/1.4986047
- ANDERS JENS ET AL: "A low-power high-sensitivity single-chip receiver for NMR microscopy", JOURNAL OF MAGNETIC RESONANCE, ACADEMIC PRESS, ORLANDO, FL, US, vol. 266, 11 March 2016 (2016-03-11), pages 41 - 50, XP029523223, ISSN: 1090-7807, DOI: 10.1016/J.JMR.2016.03.004

## Description

### Technical Field

The following description relates to a device for nuclear magnetic resonance (NMR) spectroscopy and a relative method for performing NMR spectroscopy.

### Background

The NMR spectroscopy is a spectroscopic technique that can be used, for example, to determine with exquisite specificity the chemical composition of a sample, as well as its molecular structure, in a non-destructive manner. Accordingly, the main advantages of the NMR spectroscopy are chemical specificity, non-destructiveness for the sample and the provision of a quantitative determination of the composition. Despite these advantages, NMR spectroscopy suffers from relatively low sensitivity in comparison to other spectroscopic techniques. In other words, NMR spectroscopy requires a comparatively larger amount of sample in order to reach a given signal-to-noise ratio (SNR).

One way to achieve sensitivity enhancement when dealing with mass- or volume-limited samples is the use of micro-coils, known as µ-NMR spectroscopy. However, µ-NMR spectroscopy applications suffer from some technical limitations.

One of the main challenges of the micro-coils is the loading/unloading of sub-µL samples. Two different methods have been discussed in the literature regarding the sample loading/unloading task in the micro-coils:
- Direct loading, which requires the probe to be removed, the sample to be loaded at the detection region, and the probe to be inserted back. This procedure is cumbersome, time-consuming, and prone to shimming distortion.
- Automatic loading, which requires tubes to load the sample from a reservoir into the detection region, followed by unloading the sample from the detection region via an outlet to the exterior of the system. The required tubing system is relatively large compared to the micro-coil volume, i.e. there is a rather large dead volume of sample which does not contribute to the signal. This fact defeats the very purpose of employing a micro-coil in the spectrometer for mass- or volume-limited amounts of sample.

The second challenge when using micro-coils is related to the spectral resolution of the signal. This arises from the compact nature of the micro-coil and the presence of adjacent circuits. Multiple material interfaces, being packed in a relatively small volume in the close vicinity of the detection region, introduce susceptibility mismatches that distort the static magnetic field. Besides, the tuning/matching circuits, which are usually next to the micro-coil, introduce further perturbations and linewidth broadening.

Multi-nuclear detection is another aspect of NMR spectroscopy that enables detection of different NMR active nuclei during a single experiment. It is a popular technique to investigate molecular structures. Nevertheless, relatively low impedance of the micro-coils, with respect to the trap and tank circuits required for multinuclear detection, degrades their sensitivity in multinuclear applications. Efficiency of the micro-coils for multi-nuclear detection is still a challenge to be addressed.

Further, µ-NMR spectroscopy as well as conventional NMR spectroscopy focus on liquids or solids formed into cylindrical samples, usually NMR tubes for liquids and magic-angle spinning (MAS) rotors for solid materials. The MAS rotors are not suitable for performing NMR spectroscopy on solid thin film samples having quasi-planar topology. The reason is the low filling factor of the coil, which leads to a low SNR. Accordingly, adjustments to thin film samples would be required, which is neither time- nor cost-efficient.

In particular, energy storage devices, such as batteries and supercapacitors, form an important class of thin film applications that could greatly benefit from NMR spectroscopy. However, the metallic current collectors of such devices shield the radio frequency (RF) field. Therefore, the penetrated field inside the device is degraded and the detection sensitivity is decreased. The low sensitivity is a challenge especially for in-situ experiments, i.e. during the operation of the energy storage device.

US 2002/0190715 A1 discloses an RF receiver coil arrangement for the reception of measuring signals from a measuring sample in the measuring volume of an NMR spectrometer comprising an RF resonator having superconducting, inductively and capacitively acting conducting structures, which form resonant circuits, on planar substrate elements and which are disposed about the measuring sample, which is characterized in that each individual current-carrying resonant circuit on the planar substrate element produces a magnetic field in the center of the measuring volume, which is parallel to the plane of the planar substrate element, on which the individual resonant circuit is located, wherein the deviation from parallelism, does not exceed 40 degrees.

### Summary

It is an object of the invention to improve the sensitivity of NMR spectroscopy, in particular of NMR spectroscopy for mass- or volume-limited samples and for thin film applications. The achievement of this object in accordance with the invention is set out in the independent claims. Further developments of the invention are the subject matter of the dependent claims.

According to one aspect, a device configured to be inserted in an NMR spectrometer for analysing a sample is provided. The device comprises:
a first conductive loop comprising a first straight portion; and
a second conductive loop comprising a second straight portion;
wherein each conductive loop is formed as a strip whose extremities coincide with each other to define an enclosure and wherein the first conductive loop and the second conductive loop are arranged such that:
a first plane containing the first conductive loop is substantially parallel to a second plane containing the second conductive loop, wherein a space between the first plane and the second plane is a middle space;
the first straight portion is substantially parallel to the second straight portion;
a third plane containing the first straight portion and the second straight portion is substantially perpendicular to the first and second planes, wherein the third plane defines a first half-space and a second half-space and wherein the intersection between the third plane and the first plane defines a first direction;
a projection of the second straight portion on the first direction overlaps at least partly with the first straight portion;
the first conductive loop is located in the first half-space and the second conductive loop is located in the second half-space;
the middle space is adapted to receive at least part of the sample at a position between the first straight portion and the second straight portion.

A conventional NMR spectrometer comprises a strong magnet that generates a static magnetic field (denoted as *̅B̅*̅₀, e.g. along the nominal z-axis) and a probe comprising at least one radio frequency (RF) coil that generates an oscillating magnetic field (denoted as *̅B̅*̅₁, e.g. along the nominal y-axis), which is perpendicular to the static magnetic field. The probe is located within a bore in the middle of the magnet and the sample is contained in a tube that is positioned within the probe.

The RF coil is usually a saddle coil. The standard NMR RF coil usually has dimensions in the order of few millimetres, e.g. the diameter between about 2 mm and about 20 mm and the length between about 5 mm and about 70 mm. As an example, a saddle coil being 20 mm in length and 11 mm in diameter is considered here and the dimensions of the device are given for such case. However, it should be emphasised that the performance of this device is not limited to this case and can be modified for any arbitrary coil dimensions.

The device according to the invention is configured to be inserted in an NMR spectrometer, in particular within the probe of the NMR spectrometer. In other words, the features of the device, such as its size and the constituent materials, make it suitable for being inserted within a conventional NMR spectrometer, specifically within its probe, more specifically inside the coil. Exemplary values for the dimensions of the device and examples for the materials of its components will be described later in this document.

Further, the device is configured to be used in the NMR spectrometer for analysing a sample. Thus, the device is not only suitable to be placed in the NMR spectrometer, rather it is also configured to contribute to the analysis of the sample. Indeed, as explained below, the device enhances the intensity of the oscillating magnetic field at the sample region and simultaneously changes its direction while the analysis is being performed, thereby increasing the sensitivity of the NMR spectrometer.

The device comprises a first conductive loop and a second conductive loop. Unless otherwise specified, the term "loop" or "conductive loop" refers to both the first conductive loop and the second conductive loop. A loop is conductive in the sense that it can conduct electric current. Accordingly, each loop is made of a material that is a conductor, such as a metal (e.g. copper). The conductor is in the shape of a loop, i.e. it is formed as a strip whose extremities coincide with each other to define an enclosure. The loops are substantially planar.

Exemplarily, the strip may be formed by patterning a thin metallic layer or may be formed on a printed circuit board (PCB), e.g. as microstrip or stripline. Accordingly, in some examples, the device may comprise at least one base layer for each loop, i.e. a first base layer and a second base layer.

The strip has a length, a width and a thickness, wherein the length is greater than the width, which in turn is greater than the thickness. The length of the strip is the perimeter of the enclosure defined by the loop. The thickness of the strip may be substantially constant along the length. The width may be substantially constant along the length of the strip or it may vary between different portions of the loop.

As explained below, electrical current is induced in the loops by the oscillating magnetic field. One factor to consider when setting the dimensions of the strip is the resistance, which should be minimized. In this context, the skin effect may be taken into account, so that the thickness of the strip may be set e.g. to more than twice the skin depth. The skin depth is determined by the material of the strip and by the frequency of the alternating current (i.e. of the oscillating magnetic field).

Exemplary value ranges for the dimensions of the strip are as follows: the length may be in the order of tens of mm, e.g. between about 14 mm and about 46 mm, the width may be in the order of hundreds of µm, e.g. between about 100 µm and about 2 mm and the thickness may be in the order of tens of µm, e.g. between about 10 µm and about 50 µm. In particular, the length may be between about 20 mm and about 36 mm (e.g. about 28 mm), the width may be between about 200 µm and about 600 µm and the thickness may be between about 20 µm and about 40 µm (e.g. about 36 µm). The strip may have the same dimensions in both loops.

The first conductive loop comprises a first straight portion and the second conductive loop comprises a second straight portion. Each straight portion is a segment of the strip that is not curved and forms no angles. In particular, in the context of this description, the term "straight portion" refers to a piece of strip whose shape can be approximated by a line segment. Further, the term "straight" is also meant to account for manufacturing irregularities. Accordingly it may also be said that the portion is substantially straight.

The first straight portion and the second straight portion may have the same length, e.g. between about 5 mm and about 18 mm, exemplarily of about 10 mm. The length of the straight portions may be chosen based on the length of a conventional RF coil, e.g. between 25% and 100% of the length of the RF coil, further exemplarily at least about 50% of the length of the RF coil. As mentioned above, the width is of the order of hundreds of micrometres. For example, each straight portion may have a width between about 100 µm and about 400 µm, e.g. 200 µm. The width may be constant along the straight portion or vary. If the width is not constant along the straight portion, average width is meant under "width of the straight portion".

The rest of the loop excluding the straight portion may be referred to as "remaining portion", so that the loop is made up by a straight portion and a remaining portion. The remaining portion may be curved and/or comprise other straight portions. Exemplarily, the loop may have a rectangular shape, so that the remaining portion comprises three further straight portions. The straight portion in a rectangular loop may be the longer side of the rectangle.

For instance, a rectangular loop may have a length between about 5 mm and about 18 mm (e.g. about 10 mm), i.e. equal to the length of the straight portion, and a width between about 2 mm and about 5 mm (e.g. about 4 mm). The width of the loop may correspond approximately to or be smaller than the radius of a conventional RF coil, e.g. it may be between 60% and 95% of the radius of the RF coil, further exemplarily about 80% of the radius of the RF coil. The first conductive loop and the second conductive loop may have the same shape and size or may have a different shape and/or size.

In each loop, the remaining portion may have a different width than the straight portion, exemplarily the width of the remaining portion may be larger than two times the width of the straight portion. For example, the remaining portion may have a width between about 300 µm and about 2 mm, e.g. 600 µm.

The first conductive loop and the second conductive loop are arranged in a specific configuration with respect to each other. Firstly, they are arranged such that a first plane containing the first conductive loop is substantially parallel to a second plane containing the second conductive loop.

It should be noted that the first plane and the second plane (as well as the third plane discussed below) are abstract geometrical entities that are used as aids in describing the arrangement of the first conductive loop and the second conductive loop, and they are not actual components of the device.

Further, the first plane and the second plane are not strictly two-dimensional entities, but rather sheets that extend infinitely in two dimensions and that have a finite size in the third dimension, which is negligible with respect to infinite. The reason the planes have a finite size in one dimension is that the loops are real objects with a finite thickness, e.g. in the order of tens of micrometres as mentioned above. Further, the loops may not be perfectly planar, e.g. due to manufacturing tolerances. Accordingly, each plane has a thickness corresponding to the thickness of the loop plus, optionally, an amount accounting for manufacturing irregularities.

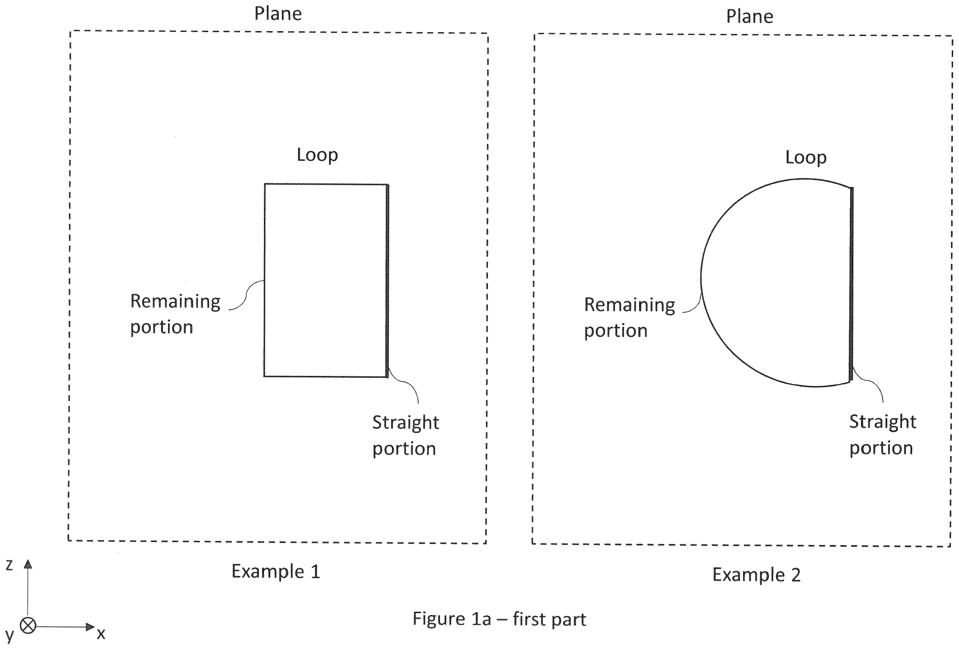

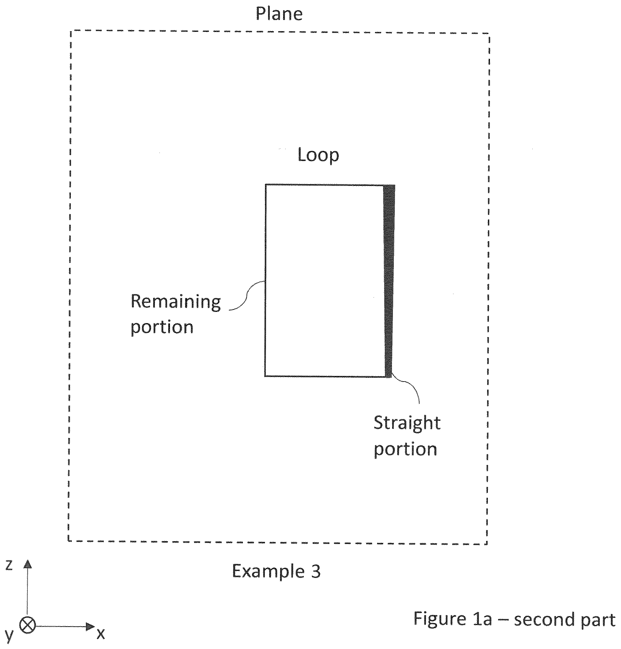

Three non-limiting examples of a conductive loop and the abstract plane in which it is contained are shown in **Figure 1a****.** The representation of the infinitely-extending plane is a rectangular-shaped part thereof, which is indicated with dashed lines. The loops in Figures 1a to 8 are not to scale. The straight portions are indicated by a thicker line only to facilitate visual identification, but this bears no relation to actual widths of the straight portions and remaining portions.

As mentioned above, the straight portions can, in a first approximation, be represented as line segments, in virtue of their shape as well as the fact that one dimension (the length) is dominant over the other two. However, the straight portions have a finite width, as discussed previously. Accordingly, in a second approximation, the shape of a straight portion in its plane may be substantially rectangular, i.e. be a convex quadrilateral having four substantially right angles. A substantially right angle may be in the range between about 88° and about 92°. For example, the shape may be a rectangle (as shown in Examples 1 and 2 of Figure 1a) or a isosceles trapezoid (as shown in Example 3 of Figure 1a). Both these shapes can be approximated by a line segment, when the width is considerably smaller than the length.

The first plane and the second plane are substantially parallel to each other. "Substantially parallel" here means that the two planes either never intersect each other or intersect each other forming an angle greater than about 0° and smaller than about 5°, in particular smaller than about 2°.

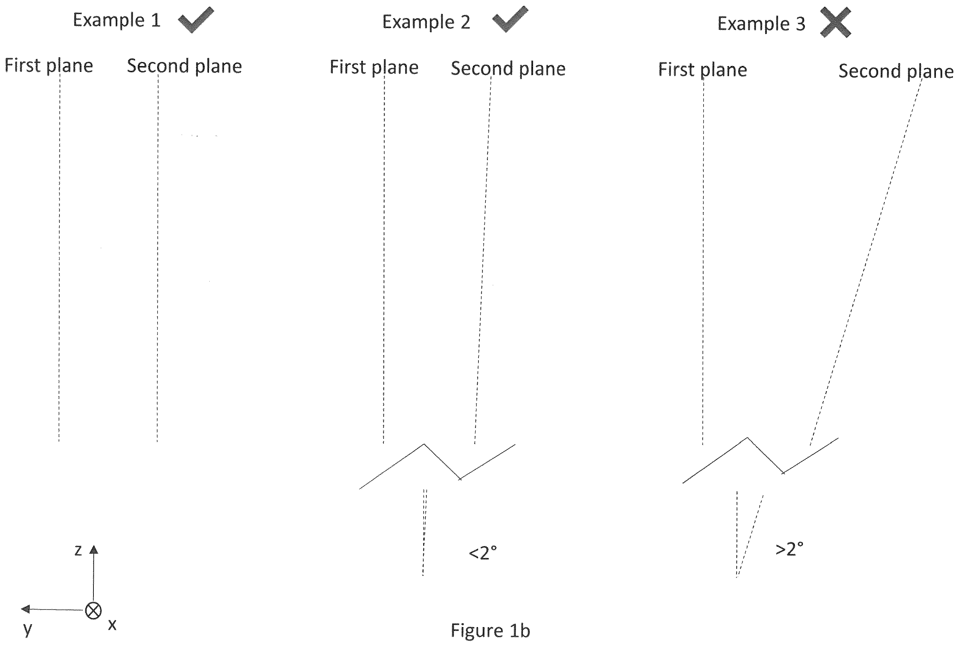

**Figure** 1b shows three exemplary arrangements of the first plane containing the first conductive loop and the second plane containing the second conductive loop: in example 1 the planes never intersect each other (parallel planes) and in example 2 they form an angle smaller than 5°. Accordingly, both examples 1 and 2 show an arrangement of the loops such that their planes are substantially parallel. On the contrary, example 3 shows two planes that form an angle greater than 5° and are, thus, not substantially parallel.

With reference to a three-dimensional Cartesian coordinate system, the first plane and the second plane may extend infinitely in the x and z directions and have a finite thickness in the y direction. This illustrative orientation will be used in the present description, although it is apparent that any other orientation is equivalent.

Secondly, the first conductive loop and the second conductive loop are arranged such that the first straight portion is substantially parallel to the second straight portion and a third plane containing the first straight portion and the second straight portion is substantially perpendicular to the first and second planes.

As described above, each straight portion has one dimension (the length) that is about two or three orders of magnitude larger than the other two dimensions, so that each straight portion can be considered in first approximation as one-dimensional. In the illustrative orientation, the length of a straight portion is along the z direction, the width thereof is along the x direction, and the thickness thereof is along the y direction.

The requirement that the first straight portion is substantially parallel to the second straight portion is a constraint on the relative orientation of the two loops. Of all the possible configurations that could be obtained by rotating a loop in its plane while keeping the other loop fixed, the orientation in which the two straight portions are substantially parallel to each other is selected. In other words, it is excluded that the straight portions are skew segments. Exemplarily, each straight portion may be substantially parallel to the z axis.

"Substantially parallel" here means that, if the first straight portion were orthographically projected on the second plane (or the second straight portion were orthographically projected on the first plane), a line containing the first straight portion and a line containing the second straight portion would either coincide with each other, or not intersect each other or intersect each other forming an angle greater than about 0° and smaller than about 2°, in particular smaller than about 1°. Thus, the angle between these abstract lines are so small that variations in the distance between segments would be smaller than the width of segments, when the segments have the length of the straight portions.

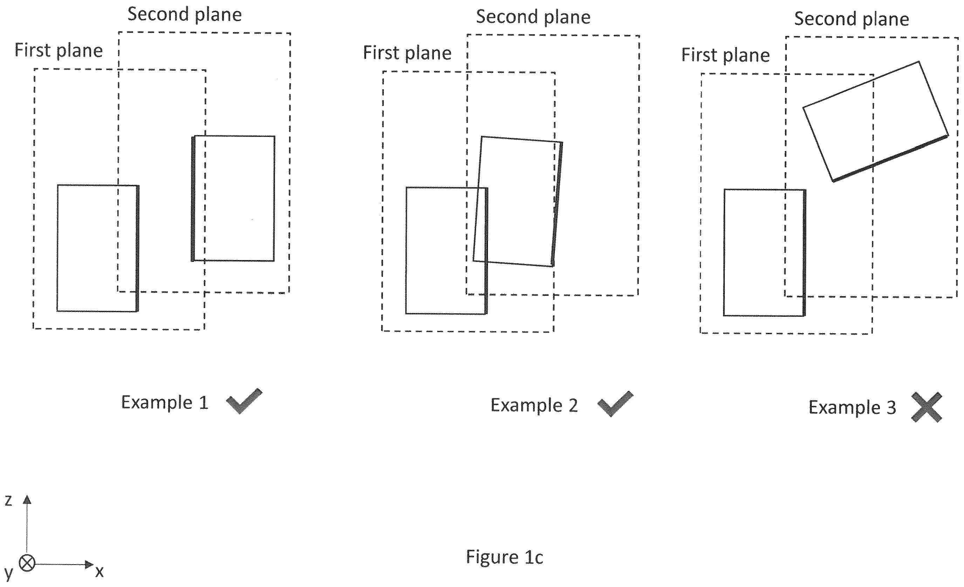

**Figure** 1c shows different possible orientations between the two loops. In example 1 the straight portions are perfectly parallel to each other (they do not intersect each other) and in example 2 the lines containing the (projected) straight portions form an angle smaller than about 2°. Accordingly, examples 1 and 2 show loops arranged such that the first straight portion is substantially parallel to the second straight portion. On the contrary, example 3 shows a relative orientation between the loops that puts the straight portions at an angle greater than 2°. Thus, the loops are not arranged such that the first straight portion is substantially parallel to the second straight portion.

Accordingly, there exists a plane that contains both the first straight portion and the second straight portion, the third plane. Similarly to the first and second planes, the third plane extends infinitely in two dimensions and has a negligible, but finite size in the third dimension. The thickness of the third plane corresponds to the width of the straight portions plus, optionally, an amount accounting for deviations from perfect parallelism within the extent of the straight portions.

The requirement that the third plane be substantially perpendicular to the first and second planes is a constraint on the relative position of the two loops. Specifically, it is a constraint on the relative position of the two loops relative to a direction (e.g. x direction) perpendicular to the straight portions in the first and second planes. The first conductive loop and the second conductive loop are arranged such that the straight portions are substantially aligned with each other.

"Substantially perpendicular" here means that the third plane and the first plane (or the second plane) form an acute angle between about 88° and about 90°, exemplarily between about 88° and about 90°, or a right angle of about 90°. The third plane may, thus, extend infinitely in the y and z directions and have a finite thickness in the x direction.

In other words, if the first straight portion were orthographically projected on the second plane (or the second straight portion were orthographically projected on the first plane), a line containing the first straight portion and a line containing the second straight portion would either coincide with each other or the maximum distance between them would be negligible with respect to the width of the straight portions, e.g. in the order of few micrometres, and/or lower than a predetermined threshold.

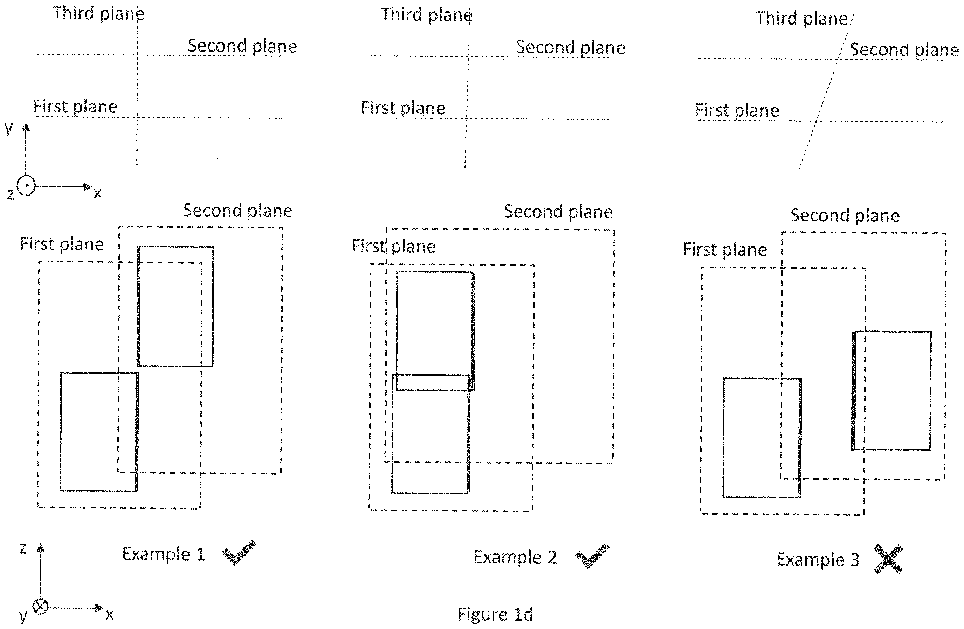

**Figure 1d** shows different relative positions along the x axis between the two loops. In example 1 the straight portions are perfectly aligned to each other (the lines containing them would coincide) and in example 2 the lines containing the (projected) straight portions have a constant distance, with the third plane forming an acute angle greater than 88°. Accordingly, examples 1 and 2 show loops arranged such that the third plane is substantially perpendicular to the first and second planes, as shown in the upper part of the figure. On the contrary, example 3 shows a relative position between the loops along the x axis in which the third plane forms an acute angle lower than 88° with the first and second plane, and, thus, is not substantially perpendicular thereto.

The intersection between the third plane and the first plane defines a first direction, which is the same as the direction along which the first straight portion extends, e.g. the z direction. Thirdly, the first conductive loop and the second conductive loop are arranged such that a projection of the second straight portion on the first direction overlaps at least partly with the first straight portion.

Alternatively, it could be said that a second direction is defined by the intersection between the third plane and the second plane and then the requirement would be that the first conductive loop and the second conductive loop are arranged such that a projection of the first straight portion on the second direction overlaps at least partly with the second straight portion.

Indeed, the term "direction" in this context is meant to refer to a straight line and its orientation plays no role. Also its specific position, whether on the first plane (first direction) or on the second plane (second direction) is irrelevant. The first direction and the second direction are parallel to each other, so that they have a common "path of extension" of within the space (which is e.g. parallel to the z direction), and only this "path of extension" is of relevance.

This requirement is another constraint on the relative position of the two loops. Specifically, it is a constraint on the relative position of the two loops relative to the direction (e.g. z direction) along which the straight portions extend on the first and second planes, i.e. the first direction. The first conductive loop and the second conductive loop are arranged such that not only their straight portions are aligned with each other, but also face each other at least partly.

Said otherwise, the range of coordinates of the extension of the first straight portion measured along the first direction (e.g. z coordinates) and the range of coordinates of the extension of the second straight portion in the first direction have a non-void intersection. The intersection can be denoted as "overlapping section" between the first straight portion and the second straight portion, when projected on the first direction.

If the length of the first straight portion is L1 and the length of the second straight portion is L2, the length of the overlapping section may exemplarily be at least 0.15*(L1+L2), further exemplarily at least 0.25*(L1+L2), yet further exemplarily 0.5*(L1+L2). In a particular example, the length of the first straight portion, of the second straight portion and of the overlapping section may be identical, i.e. coincide with each other. In other words, the first straight portion and the projection of the second straight portion may overlap completely with each other, i.e. coincide.

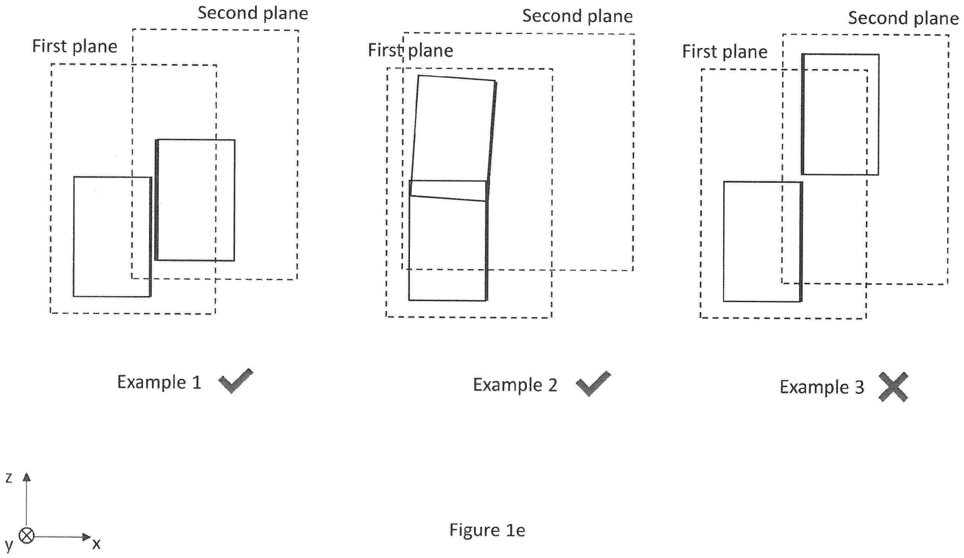

**Figure 1e** shows different relative positions along the z axis between the two loops. In example 1 the components of the straight portions on the z axis have a substantial overlap and in example 2 the components of the straight portions on the z axis have a small overlap. Accordingly, examples 1 and 2 show loops arranged such that the straight portions (when one is projected on the other) overlap at least partly with each other. On the contrary, example 3 shows a relative position between the loops along the z axis in which the two straight portions have no overlap with each other.

Each plane divides the space into two half-spaces and, in particular, the third plane defines a first half-space and a second half-space. Fourthly, the first conductive loop and the second conductive loop are arranged such that the first conductive loop is located in the first half-space and the second conductive loop is located in the second half-space. Since the straight portions are parts of the loop and are parts of the third plane, the closed half-spaces are meant here.

This requirement is another constraint on the relative orientation of the loops. The requirement that the first straight portion is substantially parallel to the second straight portion excluded all relative orientations that are not substantially 0° or substantially 180°. This constraint further selects only one between these two orientations, namely substantially 180°.

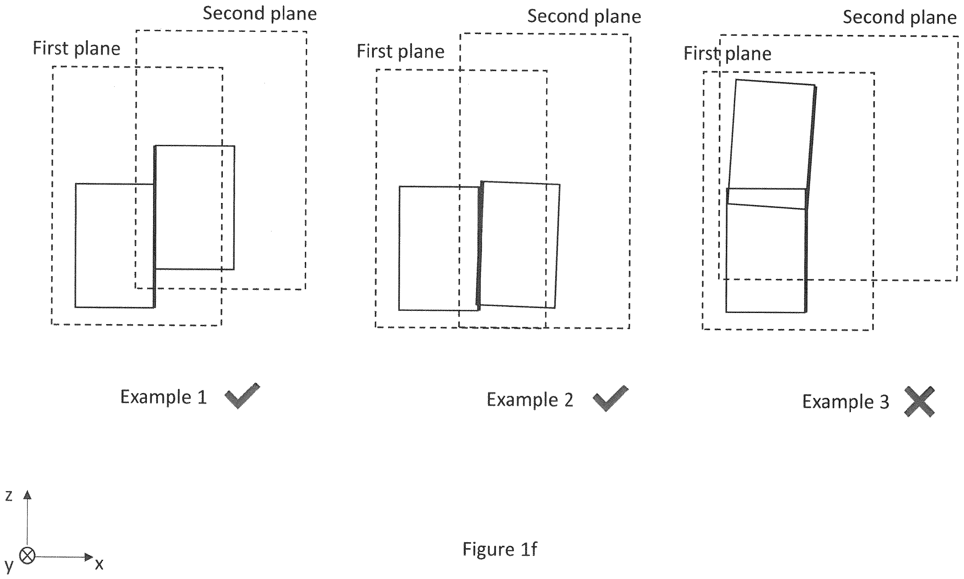

**Figure 1f** shows different relative orientations between the two loops. In example 1 the relative orientation is 180° and in example 2 the relative orientation is close to 180°. Accordingly, examples 1 and 2 show loops arranged such that the first conductive loop is located in the first half-space and the second conductive loop is located in the second half-space. On the contrary, example 3 shows a relative orientation between the loops close to 0°, so that the both loops are in the same half-space.

The space between the first plane and the second plane is denoted as middle space. Lastly, the first conductive loop and the second conductive loop are arranged such that the middle space is adapted to receive the sample at a position between the first straight portion and the second straight portion.

Consequently, the distance between the straight portions (i.e. the width of the band of the third plane contained in the middle space) is always greater than zero. More generally, the distance between the loops is greater than zero. Accordingly, even if the first and second planes are not perfectly parallel and form an angle, they never meet at the position of the loops. Since, even in this case, the angle is so small, the distance between the first plane and the second plane is substantially constant along the extent of the loops.

For example, the distance between the first conductive loop and the second conductive loop, and in particular between the first straight portion and the second straight portion, may be in the order of hundreds of micrometres, e.g. between about 100 µm and about 500 µm, further exemplarily between about 150 µm and about 400 µm, yet further exemplarily about 200 µm.

Said otherwise, the first conductive loop and the second conductive loop are arranged such that the middle space is adapted to receive the sample at a position intersecting the third plane in correspondence of the overlapping section. In the illustrative orientation, this means there is an overlap between the sample and the straight portions along the x direction. Further, there is an overlap between the sample and both of the straight portions along the z direction, i.e. between the sample and the overlapping section.

To summarize, the conductive loops are positioned in a specific configuration with respect to each other, which, in particular, enables at least part of a sample to be interposed between the first straight portion and the second straight portion. The configuration of the device described heretofore confers the device the following functionality.

When the device is placed within the probe of an NMR spectrometer in such a way that the first and second planes are substantially perpendicular to the direction of the oscillating magnetic field *̅B̅*̅₁, the loops flip and enhance this magnetic field at the middle space. More precisely, a secondary magnetic field *̅B̅*̅₂ with a greater strength than *̅B̅*̅₁ is induced between the first straight portion and the second straight portion in correspondence of the overlapping section, as explained in the following.

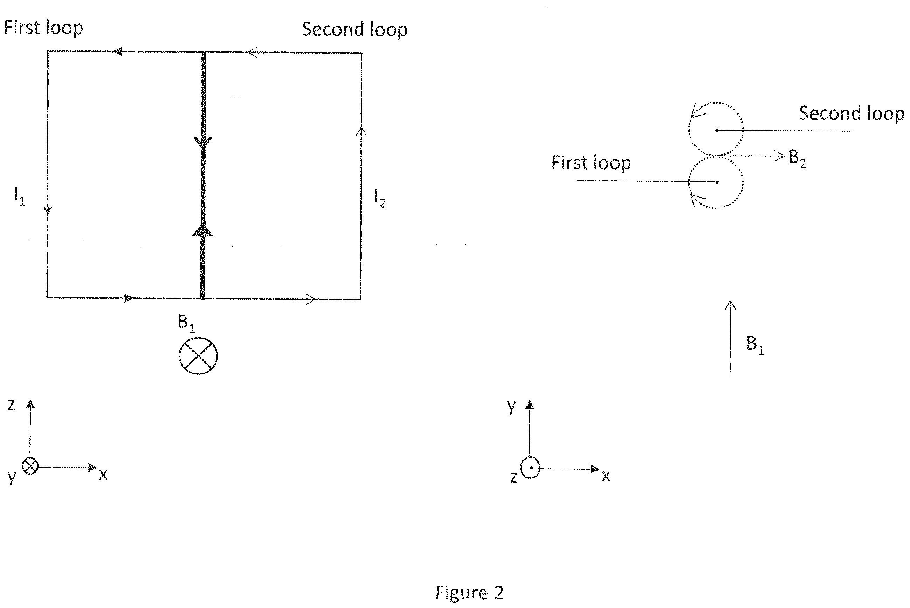

The oscillating magnetic field *̅B̅*̅₁ induces a current in each of the first conductive loop and second conductive loop, the direction of which is determined by Lenz's law. In particular, because of the relative orientation and position of the loops described above, the direction of the induced current in the first straight portion is the opposite of the direction of the induced current in the second straight portion. This is shown in the example on the left side of **Figure 2****,** in which the oscillating magnetic field *̅B̅*̅₁ is in the *y* direction and the currents *̅I̅*̅₁ and *̅I̅*̅₂, induced in the first conductive loop and second conductive loop, respectively, are in the counter-clockwise direction. In the first straight portion the current flows in the z direction and in the second straight portion the current flows opposite the z direction.

In turn, the current flowing in each straight portion produces an induced magnetic field, which is concentric with respect to the straight portion and whose intensity (or strength) decreases with increasing distance from the straight portion. Because of the opposite directions of the induced current, the first induced magnetic field produced by the first straight portion and the second induced magnetic field produced by the second straight portion have opposite directions with respect to each other. This means that e.g. the direction of the first induced magnetic field around the first straight portion is clockwise and the direction of the second induced magnetic field around the second straight portion is counter-clockwise. This is shown in the example on the right side of Figure 2.

The vector of each induced magnetic field can be decomposed in two orthogonal components, one parallel to the first and second planes and one perpendicular thereto (i.e. parallel to the third plane). As described previously, there is a non-zero distance between the first straight portion and the second straight portion. In this middle space, the perpendicular components of the first and second induced magnetic field have opposite directions, while the parallel components have the same direction. Accordingly, in the middle space the induced magnetic fields superimpose constructively in the direction parallel to the first and second planes.

The result of this superimposition is the secondary magnetic field *̅B̅*̅₂, which is perpendicular to the oscillating magnetic field *̅B̅*̅₁ as well as to the straight portions. As shown in the example on the right side of Figure 2, if the oscillating magnetic field *̅B̅*̅₁ is in the y direction and the straight portions extend in the *z* direction, the secondary magnetic field *̅B̅*̅₂ is in the *x* direction.

In particular, between the straight portions (i.e. at the section of the third plane in the middle space) each induced field reduces substantially to its parallel component. Accordingly, in the region sandwiched between the straight portions the superimposition of the first induced magnetic field and the second induced magnetic field is fully constructive, so that *̅B̅*̅₂ has the greatest strength. The greater the intensity of the secondary magnetic field, the higher the sensitivity of the NMR spectroscopic analysis for all frequencies corresponding to different NMR-active nuclei and different static magnetic fields (*̅B̅*̅₀).

The whole spatial arrangement of the loops and the tolerances within it as illustrated previously must be considered in view of the function of the device. In particular, if the straight portions are not perfectly parallel, as e.g. shown in example 2 of Figure 1f, and/or if the third plane is not perfectly perpendicular to the first and second planes, as e.g. shown in example 1 of Figure 1e, the strength of *̅B̅*̅₂ may not be maximised, at least not along the whole length of the overlapping section. In comparison, the exemplary configuration of example 1 of Figure 1f maximises the strength of *̅B̅*̅₂ along the whole length of the overlapping section. On the other hand, the extension of the region in which *̅B̅*̅₂ is significantly present is smaller in example 1 of Figure 1f with respect to example 2 of Figure 1f, which means that a lower sample volume can be considered.

Therefore, the enhancement of the sensitivity may be maximised in a particular, exemplary configuration in which the first straight portion and the second straight portion would substantially coincide when projected on a common plane parallel to the loops.

The part of the middle space in which the secondary magnetic field has an intensity such that an enhancement factor defined as |*̅B̅*̅₂|/|*̅B̅*̅₁| is greater than 1 may be denoted as detection region.

According to the configuration described above, the device is arranged such that at least part of the sample is located in the detection region. The detection region is a region in space that substantially has as length the length of the overlapping section and as thickness the distance between the first straight portion and the second straight portion. The width of the detection region depends on the specifics of the device and might extend beyond the width of the straight portions.

Considering Faraday's law of induction, the electromotive force is given by the rate of change of the magnetic flux, which in turns depends on the surface enclosed by the loop. Further, the intensity of each induced magnetic field depends on the distance from the straight portion. Therefore, the intensity of the secondary magnetic field *̅B̅*̅₂ depends on the area enclosed by each loop and the separation between the two straight portions (distance between first plane and second plane at the location of the straight portions).

On the other hand, the separation between the two straight portions determines the volume of the sample that can be analysed.

Accordingly, the area of the loops may be chosen to maximise the intensity of *̅B̅*̅₂, while the distance between the straight portions may be chosen considering the trade-off between sample volume and field intensity for sensitivity. Exemplary lower limits to obtain an enhancement factor greater than 1 may be: area of the loops equal to or greater than about 10 mm², further exemplarily equal to or greater than about 20 mm², yet further exemplarily equal to or greater than about 30 mm²; separation between about 100 µm and about 500 µm, further exemplarily between about 150 µm and about 400 µm, yet further exemplarily about 200 µm.

Upper limits for the area may be given by the size of the RF coil in the NMR spectrometer, as already mentioned above. For example, the area of each loop may be equal to or smaller than about 90 mm², further exemplarily equal to or smaller than about 60 mm², yet further exemplarily equal to or smaller than about 50 mm².

In particular, if each loop is a rectangular loop with length *L* (which is the length of the straight portion) and width *W* and the separation or distance between the straight portions is *D,* the enhancement factor *B₂*/*B₁* is proportional to the ratio *W*/*D.*

Accordingly, *W* should be maximised and/or *D* should be minimised. Exemplarily, W may be at least two times *D.* These parameters may be exemplarily chosen such that the ratio *W*/*D* is equal to or greater than 5, further exemplarily equal to or greater than 10, yet further exemplarily equal to or greater than 15. An upper limit for *W* may be given by the radius of the RF coil: W may be equal to or smaller than the radius of the coil, further exemplarily equal to or smaller than about 95% of the coil radius. As already mentioned, a lower limit on *D* may be given by a thickness of the sample that is to be analysed. If the first conductive loop and the second conductive loop are rectangles with different widths *W₁* and *W₂*, the ratio *(W₁*+*W2)*/*2D* should be considered instead.

Another characteristic that influences the enhancement factor is the width of the strip at the straight portion, *S.* The intensity of the secondary magnetic field, *B₂*, is a function of the current density in the straight portion and the current density is inversely proportional to the width of the straight portion, *S.* By increasing *S,* on one hand, *B*₂ is reduced and, on the other hand, homogeneity of the secondary magnetic field over the middle space is enhanced. Accordingly, the enhancement factor is inversely proportional to S, which, thus, should be minimised, while considering the trade-off with homogeneity. Exemplarily, *S* may be set such that the ratio *S*/*D* is equal to or smaller than 2, further exemplarily equal to or smaller than 1.

However, it should be noted that current and, consequently, *B*₂ depend on the resistance of the strip, which is determined, among other factors, by the width of the strip along the whole loop. The width of the strip at the remaining portion, *R,* shall be selected larger than S in order to lower the resistance (and increase *B₂*). Exemplarily, *R*/*S* may be equal to or greater than 2, further exemplarily equal to or greater than 3.

To summarize, the device described herein acts as an adaptor which mediates between the RF coil (e.g. a commercial saddle coil) and the sample. As a passive element, it "collects" the oscillating magnetic field (also referred to as "first magnetic field") generated by the RF coil and "concentrates" it uniformly at the detection region, where the sample is located. More precisely, the device passively generates a secondary magnetic field with an intensity amplified with respect to the intensity of the first magnetic field. Further, the secondary magnetic field is perpendicular to the oscillating magnetic field.

The higher strength of the secondary magnetic field compared to the first magnetic field increases the sensitivity of the spectroscopic analysis and, thus, makes the device particularly advantageous for mass- or volume-limited samples.

The planar geometry of the device makes it especially useful for thin film samples, e.g. with a thickness smaller than 500 µm. The sample can be sandwiched between the loops of the device and the assembly can be inserted into the probe inside the magnet for analysis. By providing a focussed magnetic field at the sample location, the device enhances the filling factor of the coil. Therefore, the device is a suitable adaptor for samples such as sputtered thin material layers, deposited and laminated layers, spraycoated films, inkjet-printed objects, and biofilms, e.g. biological tissue slices, and even thin tissue biopsies.

The "reorientation" of the magnetic field, i.e. the fact that *̅B̅*̅₂ is perpendicular to *̅B̅*̅₁, makes the device suitable for the spectroscopic analysis of energy storage devices, which are a class of thin film samples. Indeed, the secondary magnetic field is parallel to the current collectors and can penetrate inside the material film. On top of that, the field magnification and achieved flux concentration enhance the sensitivity even more. At the same time, a key advantage is that the conductive loops may also be used as direct current terminals, for example for electrochemical biasing (battery terminals). In this way in-situ NMR measurements of energy storage devices can be performed conveniently.

It should be noted that the performance of the device is frequency independent, as long as the wavelength of the oscillating magnetic field is longer than the electrical length of the loops. It is able to perform in the whole RF range used in NMR spectroscopy, e.g. up to 2 GHz. Thus, the device can be employed for any nucleus detection and is compatible with all the magnets with different magnetic fields. Further, the device tackles the low impedance issue of micro-coils by being magnetically coupled to the RF coil, which has relatively high impedance.

In a particular example, the device may comprise a sample holder configured to hold the sample. As already mentioned, the sample should be at least partly located between the first straight portion and the second straight portion, in the detection region. Accordingly, the sample holder is configured to hold the sample at least partly in the detection region.

The specifics of the sample holder may vary depending on the characteristics of the sample to be analysed.

In some cases, if the device is configured to be used with liquid samples, the sample holder may comprise a microfluidic channel, i.e. channel with a cross-section smaller than 1 mm². The channel may be a tube open at the extremities with a substantially rectangular cross-section having a width and a height. The channel of the sample holder is placed between the first straight portion and the second straight portion.

Exemplarily, the distance between the first straight portion and the second straight portion substantially coincides with the height of the channel. In other words, the channel may be sandwiched between the first straight portion and second straight portion in direct contact with the straight portions, without other components or air in between. Accordingly, the width of the channel may be between about half and about 3 times the width of the straight portion (*S*) and the height of the channel may be equal to or smaller than the distance between the straight portions (*D*). In other examples, there may be a thin dielectric layer between the channel and each of the straight portions.

In some examples, the channel may be longer than the overlapping section, , e.g. at least 2 times longer. The length of the channel may be between about 3 cm and about 20 cm, exemplarily about 10 cm. The channel may be made of NMR compatible insulating materials with a susceptibility matched to the sample susceptibility, e.g. glass or polymer.

The sample holder may comprise an access point for loading the sample and a discharge point for unloading the sample, e.g. at opposite extremities of the channel. The access point and the discharge point (jointly denoted as "terminal points") may be regions of the sample holder communicatively connected to the channel, i.e. allowing insertion and removal, respectively, of liquid. For example, each terminal point may comprise a first aperture that matches the aperture of the channel and a second aperture, e.g. lying perpendicularly to the first aperture that is configured to receive/give the sample from/to the outside, e.g. a pipette tip. In this way, loading and unloading of the sample is facilitated.

The sample holder may further comprise a support for the channel and, optionally, the terminal points, such as a plate, made e.g. of an insulating material. The thickness of the plate may correspond to the height of the channel, the length of the plate may be (slightly) longer than the length of the channel and the width of the plate may be larger than the width of the channel and smaller than or equal to the sum of the widths of the loops. The plate and the loops may be secured to each other by means of mechanical fixators. Alternatively, the device may comprise support components configured to keep the sample holder in place, as described below.

In other cases, if the device is configured to be used with solid, thin-film samples, the solid sample can be sandwiched between the loops so that it coincides, at least partially, with the middle space. In this case, the device may not comprise a dedicated sample holder for solid samples and only comprise support components configured to keep solid samples in place, as described below.

In a particular example, the device may further comprise a first pair of conductive extensions and a second pair of conductive extensions, wherein:
the first pair of conductive extensions is arranged along the first direction and is conductively connected to the first straight portion;
the second pair of conductive extensions is arranged along the second direction and is conductively connected to the second straight portion;
the first pair of conductive extensions comprises a first upper conductive extension and a first lower conductive extension;
the first upper conductive extension and the first lower conductive extension are on opposite sides of the first straight portion;
the second pair of conductive extensions comprises a second upper conductive extension and a second lower conductive extension;
the second upper conductive extension and the second lower conductive extension are on opposite sides of the second straight portion.

Each extension is a piece of conductor, e.g. a strip of copper. The dimensions of each extension may be comparable with those of the strip of the loops. Accordingly, also the extensions are characterized by being, in a first approximation, one-dimensional. In particular, each pair of conductive extensions may have the same width and thickness as the respective straight portion. The length of an extension may be e.g. between about 1 mm and about 7 mm, exemplarily about 5 mm.

The extensions may be formed in the same manner as the loops. Each pair of conductive extensions may be formed as a single piece of strip with the respective straight portion.

A first extremity of the first straight portion is conductively connected to the first upper conductive extension and a second extremity of the first straight portion is conductively connected to the first lower conductive extension. Similarly, a first extremity of the second straight portion is conductively connected to the second upper conductive extension and a second extremity of the second straight portion is conductively connected to the second lower conductive extension.

Each pair of conductive extensions is a prolongation of the respective straight portion. It could also be said that the first pair of conductive extensions is arranged to be contained in the first plane and in the third plane and the second pair of conductive extensions is arranged to be contained in the second plane and in the third plane.

As mentioned above, a conventional NMR spectrometer comprises a strong magnet that generates a static magnetic field, *̅B̅*̅₀, which determines the spin frequency of the sample under study. At a certain applied *̅B̅*̅₀, different molecular structures or compounds result in different spin frequencies. An NMR spectrum is a collection of peaks distributed within a frequency range. The separation between the peaks in normal samples is in the order of part-per-billion (ppb) and therefore the homogeneity of *̅B̅*̅₀, field must exceed this value.

Material interfaces produce susceptibility mismatches and, according to Gauss' law, distort the magnetic field. A material interface arises at the point in which two or more different materials come into contact. Accordingly, the extremities of the straight portions, which define the boundaries of the detection region, constitute a material interface, the other material(s) being e.g. air and/or the material of the sample holder.

The extensions have the advantageous effect of pushing the material interface away from the detection region and, thus, enhancing the homogeneity of *̅B̅*̅₀, therein. These extensions have no effect on *̅B̅*̅₁, as they behave as an open circuit and current does not flow inside them.

Further, it should be noted that the device does not comprise any accompanying circuit, e.g. a tuning/matching circuit. This also contributes to minimising the susceptibility mismatch and, thus, improving spectral resolution.

In a particular example, the device may further comprise a first support component and a second support component. The first support component may be located on a side of the first conductive loop opposite the second conductive loop; and the second support component may be located on a side of the second conductive loop opposite the first conductive loop.

In other words, the first support component may be located in the half-space defined by the first plane that does not contain the second conductive loop and the second support component may be located in the half-space defined by the second plane that does not contain the first conductive loop. The first support component and the second support component sandwich the loops between them.

Each support component may comprise at least one substantially flat surface on which the respective loop may be secured, e.g. by adhesive means and/or by pressure and/or mechanical fitting. In particular, each support component may comprise a recess (or "primary recess") configured to accommodate the respective loop and the optional conductive extensions. For example, if each loop is formed on a PCB, the recess may be shaped to fit, e.g. snug fit, with the PCB. In other words, the dimensions of the recess may correspond to the dimensions of the PCB. Accordingly, once inserted in the recess of the support component, the loop (and, optionally, the extensions) may be substantially flush with the flat surface of the support component.

Further, each support component may comprise an additional recess (or "secondary recess") configured to accommodate the sample (e.g. a portion of thin film) or the sample holder. For example, if the sample holder is a plate comprising a microfluidic channel the additional recess may be configured to fit the plate. In other examples, only one of the first support component and the second support component may comprise the additional recess.

Accordingly, the first support component may comprise a first primary recess configured to accommodate the first conductive loop and the second support component may comprise a second primary recess configured to accommodate the second conductive loop. The first support component may further comprise a first secondary recess configured to accommodate the sample or the second support component may further comprise a second secondary recess configured to accommodate the sample.

The primary recess and the secondary recess may have different depths. In particular, the secondary recess may have a depth corresponding to the thickness of the sample or sample holder (if only one support component comprises the secondary recess) or half of this thickness (if both support component comprise the secondary recess). The primary recess may have a depth corresponding to the sum of the depth of the secondary recess and the depth required to accommodate the loop (e.g. the thickness of the PCB).

Accordingly, when the sample is loaded within the device, the configuration of the mounted device comprises the support components on the outer side, then the conductive loops and finally the sample at the innermost position. In other words, the sample is sandwiched between the loops, which, in turn, are sandwiched between the support components. In an exemplary configuration, each element is in direct contact with its adjacent element. Thus, as already mentioned previously, the thickness of the sample/sample holder (e.g. of a solid film or a microfluidic channel) constitutes the distance between the straight portions.

The device may be mounted by inserting the loops in the primary recesses, respectively, then inserting the sample/sample holder in the secondary recess(es) and finally fastening the support components to each other. Each support component may comprise at least one affixing portion, wherein the affixing portion of the first support component is configured to be fastened to the affixing portion of the second support component. For example, the affixing portions may be holes configured to receive fastening means, like screws.

Exemplarily, each support component may have the shape of a semi-cylinder, i.e. comprises, besides the substantially flat surface, a curved surface. In this way, when the device is assembled, it has a substantially cylindrical shape like the standard sample tubes used in NMR spectrometers. The material of the support components may be an NMR compatible insulator, e.g. polymer.

The length of the support components may be longer than the length of the sample holder and may exemplarily be between about 5 cm and about 30 cm, further exemplarily about 15 cm. The maximum width of the support components (i.e. the width of the flat surface) may be slightly larger than the sum of the widths of the loops, e.g. may be between about 4 mm and about 10 mm, further exemplarily about 9 mm. The maximum thickness of the support components (e.g. the radius of the semicircle) may exemplarily be slightly smaller than the coil radius, e.g. 5.5 mm.

The position of the primary recess along the length of each support component may be such that, once the device is inserted within the probe of the NMR spectrometer, the loops are in correspondence of the RF coil.

As already mentioned, a solid sample may be loaded in the device by inserting it into one or two secondary recesses. The solid sample may, in particular, be sized to fit into the device. A liquid sample may be introduced in the sample holder, exemplarily in the microfluidic channel via the access point, and the sample holder may then be inserted into the secondary recess(es). Alternatively, at least one support component may exemplarily comprise two apertures, a loading aperture and an unloading aperture, that may enable access to the sample holder, in particular e.g. to the terminal points. In this way, the device need not be unmounted for loading/unloading the liquid sample.

To summarize, the sample can be loaded in the support components together with the loops and the entire device can be placed inside the probe. In this manner, the device is used in an identical way as the NMR sample tubes are conventionally used, thus being fully compatible with a standard NMR system, without any further modification or adjustment to the probe. Since this loading procedure does not need extensive shim adjustment when changing the sample, the inconsistencies, which are generated by modifying the shim settings each time a new sample is being measured, are eliminated. As an additional advantage, the entire NMR analysis process is being accelerated compared to e.g. when micro-coils are used.

Another aspect of the present invention relates to a system comprising the device described heretofore and an NMR spectrometer comprising a radio frequency coil configured to generate an oscillating magnetic field; wherein: the device is positioned within the radio frequency coil such that the oscillating magnetic field is perpendicular to the first and second planes; and
the device is configured to generate a secondary magnetic field perpendicular to the oscillating magnetic field and perpendicular to the first and second straight portions, wherein the intensity of the secondary magnetic field is greater than the intensity of the oscillating magnetic field.

As already explained above, the device is to be positioned within the radio frequency coil so that the oscillating magnetic field is perpendicular to the planes defined by the conductive loops. Once the device is in this position, in virtue of its characteristics alone, specifically the capability of conducting electric current and the specific spatial arrangement of the conductive loops, the device generates the secondary magnetic field having the properties discussed above.

Yet another aspect of the present invention relates to a method of performing an NMR spectroscopic analysis. The method comprises: placing the device described heretofore within a radio frequency coil of an NMR spectrometer; placing a sample at the position between the first straight portion and the second straight portion; providing electrical current to the radio frequency coil; generating, by the radio frequency coil, an oscillating magnetic field; generating, by the device, a secondary magnetic field perpendicular to the oscillating magnetic field and perpendicular to the first and second straight portions, wherein the intensity of the secondary magnetic field is greater than the intensity of the oscillating magnetic field. Accordingly the straight portions collect the free-induction-decay signal of the spins of the sample and with the aid of the loops transfer that to the RF coil.

### Brief Description of the Drawings

Details of exemplary embodiments are set forth below with reference to the exemplary drawings. Other features will be apparent from the description, the drawings, and from the claims. It should be understood, however, that even though embodiments are separately described, single features of different embodiments may be combined to further embodiments.
Figure 1a shows a schematic representation of different examples of conductive loops.
Figures 1b to 1f show various constraints on the spatial arrangement of the conductive loops.
Figure 2 shows a schematic representation of the generation of the secondary magnetic field.
Figure 3 shows exemplary components of a device configured to be inserted in an NMR spectrometer for analysing a sample.
Figure 4 shows an example of the device configured to be inserted in an NMR spectrometer for analysing a sample.
Figure 5 shows a schematic representation of the arrangement of the device of figure 4 with respect to a RF saddle coil.
Figure 6 shows a schematic representation of the positions of the components of Figure 3 within an NMR spectrometer.
Figure 7 shows a schematic representation of the arrangement of the conductive loops with respect to the RF coil generating the oscillating magnetic field and the coil generating the static magnetic field.
Figure 8 shows a schematic representation of the conductive loops and the magnetic fields.
Figure 9 shows two plots about the dependence of the enhancement factor on some parameters of the device.

### Detailed Description

In the following, a detailed description of examples will be given with reference to the drawings. It should be understood that various modifications to the examples may be made. Unless explicitly indicated otherwise, elements of one example may be combined and used in other examples to form new examples. The figures are not to scale and some aspects (e.g. dimensions, distances, relative proportions) of the elements may vary in different figures for illustrative purposes.

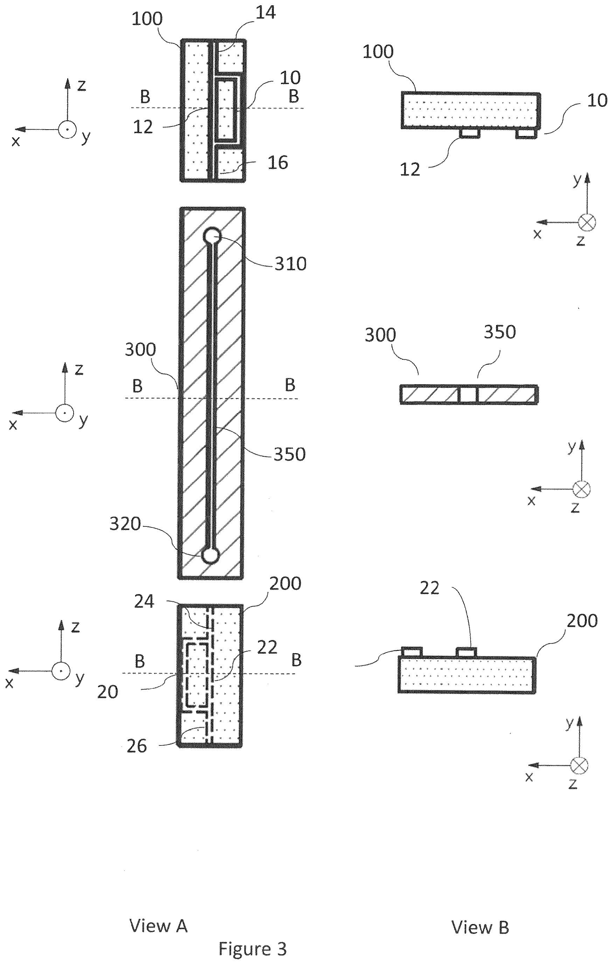

**Figure 3** shows exemplary components of a device configured to be inserted in an NMR spectrometer for analysing a sample. In particular, Figure 3 shows two printed circuit boards 100, 200 and a sample holder 300.

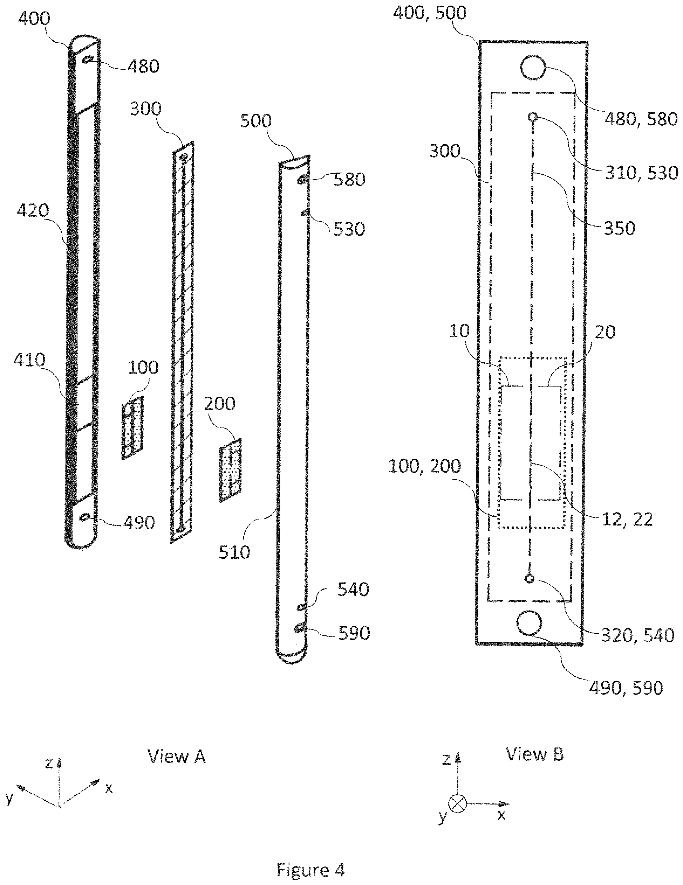

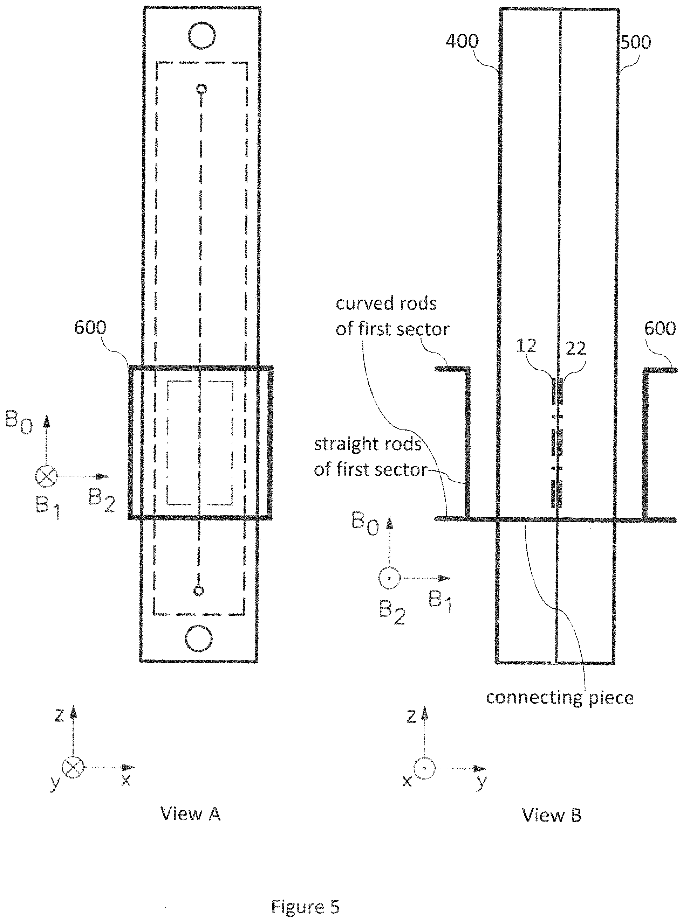

View A on the left side of Figure 3 is a front view of each component in an x-z plane, while view B on the right side of Figure 3 is an enlarged cross-sectional view of each component in an *x-y* plane. It should be noted that each component is shown separately (e.g. on parallel x-z planes in view A) for the sake of clarity, since the components overlap each other in the device, as shown in Figures 4 and 5. The components are shown with the orientation in space that they have in the assembled device when inserted in the NMR spectrometer.

The first PCB 100 and the second PCB 200 are identical to one another and, thus, interchangeable. Each PCB has conductive patterns formed thereon, e.g. as stripline made of copper with a thickness of about 36 µm.

The first PCB 100 comprises a first conductive loop 10 comprising a first straight portion 12 extending along the z direction. The first conductive loop 10 is a rectangular loop and the first straight portion 12 constitutes the length side of the rectangle located substantially centrally on the surface of the PCB 100. The first conductive loop 10 further comprises a remaining portion given by the other length side and the two width sides. The first straight portion 12 may have a length of about 10 mm and the loop width may be about 4 mm. The width of the first straight portion 12 may be about 200 µm and the width of the remaining portion may be about 600 µm.

The first PCB 100 further comprises a first pair of conductive extensions 14, 16 including a first upper conductive extension 14 and a first lower conductive extension 16. The conductive extensions 14, 16 are straight extensions of the first straight portion 12 along the z direction and may have the same width as the first straight portion 12. Each conductive extension may have a length of about 5 mm. The first pair of conductive extensions 14, 16 and the first straight portion 12 may be substantially aligned along a symmetry axis of the PCB 100 that divides it in two halves.

Accordingly, the length of the first PCB 100 may be about 20 mm and the width of the first PCB 100 may be about 8 mm. The thickness of the first PCB may be about 300 µm.

The second PCB 200 comprises a second conductive loop 20 comprising a second straight portion 22 extending along the z direction. The second conductive loop 20 is a rectangular loop and the second straight portion 22 constitutes the length side of the rectangle located substantially centrally on the surface of the PCB 200. The second conductive loop 20 further comprises a remaining portion given by the other length side and the two width sides. The second straight portion 22 may have a length of about 10 mm and the loop width may be about 4 mm. The width of the second straight portion 22 may be about 200 mm and the width of the remaining portion may be about 600 mm.

The second PCB 200 further comprises a second pair of conductive extensions 24, 26 including a second upper conductive extension 24 and a second lower conductive extension 26. The conductive extensions 24, 26 are straight extensions of the second straight portion 22 along the z direction and may have the same width as the second straight portion 22. Each conductive extension may have a length of about 5 mm. The second pair of conductive extensions 24, 26 and the second straight portion 22 may be substantially aligned along a symmetry axis of the PCB 200 that divides it in two halves.

Accordingly, the length of the second PCB 200 may be about 20 mm and the width of the second PCB 200 may be about 8 mm. The thickness of the second PCB may be about 300 µm.

The sample holder 300 comprises a plate made of insulating material supporting a microfluidic channel 350. The channel may be a tube made of glass open at the extremities with a rectangular cross-section having a width of about 200 µm and a height of about 200 µm. The channel may be about 10, cm long. The thickness of the plate may correspond to the height of the channel, the length of the plate may be about 12 cm and the width of the plate may be about 8 mm.

The sample holder 300 further comprises an access point 310 for loading the sample and a discharge point 320 for unloading the sample at opposite extremities of the channel 350. Each terminal point 310, 320 comprises a first aperture that matches the aperture of the channel and a second aperture, e.g. lying perpendicularly to the first aperture, that is configured to receive/give the sample from/to the outside, e.g. a pipette tip. In this way, loading and unloading of the sample is facilitated.

In the device, the sample holder 300 is placed between the first PCB 100 and the second PCB 200. This means that the first PCB 100 and the second PCB 200 are spaced apart along the y axis. In particular, the sample holder 300 is sandwiched between the PCBs so that the distance between the first PCB 100 and the second PCB 200 substantially coincides with the height of the channel 350.

The sample holder 300 is an optional component that may not be comprised in the device when the device is configured to be used with solid, thin-film samples. In any case, the PCBs are spaced apart to make room for the sample.

The conductive patterns on the second PCB 200 are shown as dashed lines in view A of Figure 3 because they are on the opposite surface of the second PCB 200 with respect to the surface being shown. Indeed, as shown also in view B, the PCBs are arranged so that their conductive patterns face each other.

More specifically, the PCBs are arranged in the device such that the straight portions 12 and 22 face each other and correspond to each other. In other words, while the straight portions 12 and 22 have different y coordinates because the PCBs are separated from each other along the y axis, they have substantially the same x and z coordinates. Accordingly, a projection of the first straight portion 12 along the y axis on the second PCB 200 would coincide (or completely overlap) with the second straight portion 22, and vice versa.

Since the pairs of conductive extensions are extensions of the straight portions along the z axis, also the first pair of conductive extensions and the second pair of conductive extensions correspond to each other. In particular, the first upper conductive extension 14 faces the second upper conductive extension 24 and the first lower conductive extension 16 faces the second lower conductive extension 26.

Further, the PCBs are arranged in the device such that the remaining portions of the first conductive loop 10 and of the second conductive loop 20 are on opposite sides with respect to the straight portions 12, 22. If the origin of the x axis were set at the position of the straight portions 12, 22, the remaining portion of one conductive loop would have negative x coordinates and the remaining portion of the other conductive loop would have positive x coordinates.

In figure 3, the remaining portion of the first conductive loop 10 is shown in the right half of the first PCB 100 and the remaining portion of the second conductive loop 20 is shown in the left half of the second PCB 200. However, it is understood that a reverse configuration (as shown e.g. in Figure 4), in which the remaining portion of the first conductive loop 10 is in the left half of the first PCB 100 and the remaining portion of the second conductive loop 20 is in the right half of the second PCB 200, would be equivalent.

More details about the relative arrangement of the components 100, 200 and 300 can be seen in Figure 4. **Figure** 4 shows an example of the device configured to be inserted in an NMR spectrometer for analysing a sample. In particular, view A shows an exploded view of the device and view B shows a see-through schematic view of the assembled device.

The exemplary device of Figure 4 comprises components 400 and 500 besides components 100, 200 and 300, namely a first support component 400 and a second support component 500.

Each support component has a semi-cylindrical shape comprising a flat surface and a curved surface and may be made of insulator. The length of each support component may be about 15 cm. The width of the flat surface may be about 9 mm and the radius of the semicircle may be about 5 mm.

The first support component 400 comprises a first primary recess 410 for accommodating the first PCB 100 and the second support component 500 comprises a second primary recess 510 for accommodating the second PCB 200. The shape and dimensions of the primary recesses 410, 510 are such that the PCBs are secured to the support components when inserted in the primary recesses.

Further, the first support component 400 comprises a (first) secondary recess 420 for accommodating the sample holder 300. In another example (not shown), both the first support component 400 and the second support component 500 may comprise a secondary recess, so that the sample holder 300 is partially hosted in the first secondary recess 420 and partially hosted in a second secondary recess.

The first primary recess 410 and the secondary recess 420 have different depths. In particular, the secondary recess 420 has a depth corresponding to the thickness of the sample holder and the first primary recess 410 has a depth corresponding to the sum of the depth of the secondary recess 420 and the thickness of the first PCB 100. The second primary recess 510 has a depth corresponding to the thickness of the second PCB 200.

The second support component 500 further comprises a loading aperture 530 and an unloading aperture 540, which enable access to the sample holder 300, in particular to the terminal points 310, 320. In another example (not shown), the first support component 400 may comprise loading/unloading apertures in addition to or alternatively to the ones in the second support component 500.

The first support component 400 comprises affixing portions 480, 490 and the second support component 500 comprises affixing portions 580, 590, wherein the affixing portions of the first support component 400 are to be fastened to the affixing portions of the second support component 500 by fastening means, like screws. The affixing portions are holes configured to receive the fastening means.

The device is mounted by inserting each PCB 100, 200 in its corresponding primary recess 410, 510, then inserting the sample holder 300 (or alternatively a thin, solid sample) in the secondary recess 420 and finally fastening the support components 400, 500 to each other. In this way, when the device is assembled, it has a cylindrical shape like the standard sample tubes used in NMR spectrometers.

Accordingly, when the sample is loaded within the device, the configuration of the mounted device comprises the support components 400, 500 on the outer side, then the PCBs 100, 200 and finally the sample at the innermost position. In other words, the sample is sandwiched between the PCBs 100, 200, which, in turn, are sandwiched between the support components, with each element being in direct contact with its adjacent element(s). Thus, the thickness of the sample/sample holder constitutes the distance between the PCBs 100, 200, and, thus, between the straight portions 12, 22.

As already discussed with reference to Figure 3, the extension of the first PCB 100, the second PCB 200 and the sample holder 300 is predominantly in the x and z directions, given the small thickness in they direction, so that these elements are substantially planar. In the assembled device, the first PCB 100 and the second PCB 200 are parallel to each other as well as to the sample holder 300. Similarly, the straight portions 12, 22 and the microfluidic channel 350 extend predominantly in the z direction, given the small thickness and width thereof, so that these elements are substantially linear. The first straight portion 12 and the second straight portion 22 are parallel to each other as well as to the channel 350.

Further, the first straight portion 12, the second straight portion 22 and the channel 350 are aligned with each other, as shown in particular in view B of Figure 4. In this schematic view of the device as projected on the *x-z* plane it can be seen that the two support components 400, 500 match each other, and, in particular, their affixing portions correspond to each other. Further, the loading aperture 530 of the second support component 500 is in correspondence of the access point 310 and the unloading aperture 540 is in correspondence of the discharge point 320.

The first PCB 100 and the second PCB 200 match each other and, in particular, the first straight portion 12 and the second straight portion 22 coincide with each other. The remaining portion of the first conductive loop 10 and the remaining portion of the second conductive loop 20 are instead on opposite sides of the straight portions.

The position of the primary recess along the length of each support component is such that, once the device is inserted within the probe of the NMR spectrometer, the conductive loops 10, 20 are in correspondence of the RF coil. **Figure 5** shows a schematic representation of the arrangement of the device of figure 4 with respect to a RF saddle coil 600. For the sake of clarity, the PCBs are omitted in view A, while in view B only the RF coil 600, the straight portions 12, 22 and the support components 400, 500 are shown.

The RF coil 600 is a saddle coil (or paired saddle coil) having, for example, a length (measured along the *z* axis) of about 20 mm and a radius (measured along the *y* axis) of about 5.5 mm. A saddle coil can be considered as comprising two sectors connected to one another by a connecting piece, wherein each sector comprises two parallel straight rods connected at their extremities by two curved rods to form a semi-cylinder. Accordingly, each pair of straight rods defines a plane containing both rods.

The relative position and orientation between the RF coil 600 and the device are such that the oscillating magnetic field *̅B̅*̅₁ generated by the RF coil 600 is perpendicular to the PCBs 100, 200 and the sample holder 300. In other words, the planes defined by each pair of straight rods are x-z planes and, thus, parallel to the PCBs 100, 200 and the sample holder 300, while the straight rods extend along the z direction. The oscillating magnetic field *̅B̅*̅₁ is in they direction.

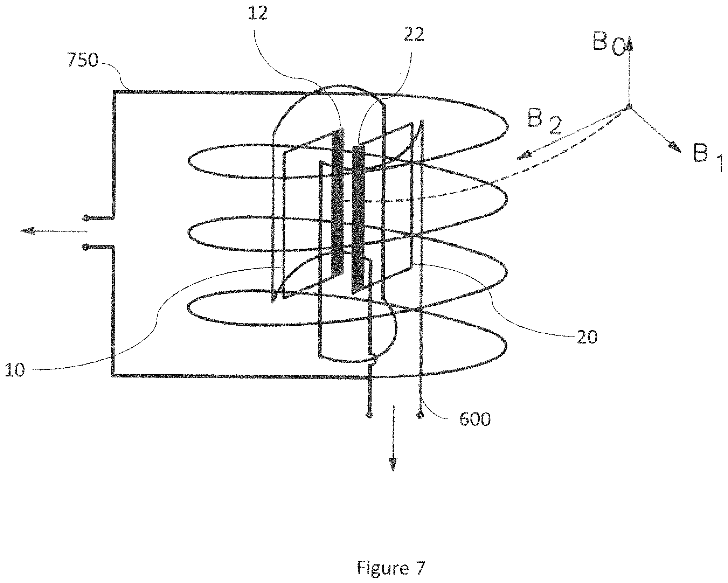

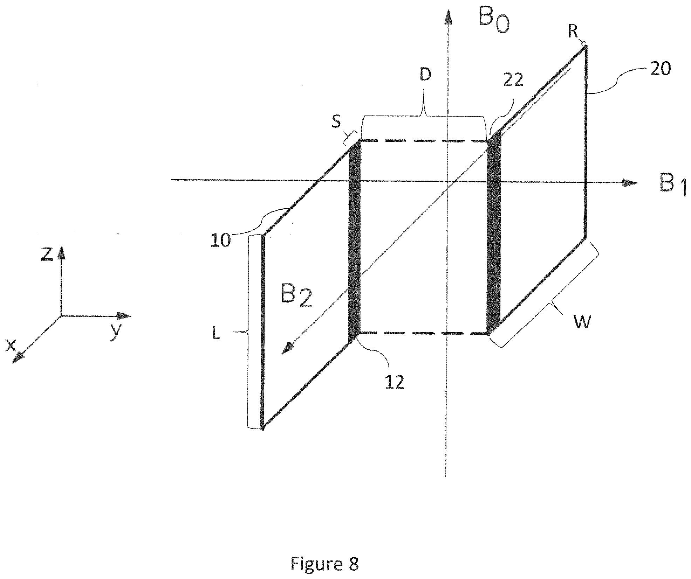

As discussed in more detail with reference to Figures 7 and 8 below, the first conductive loop 10 and the second conductive loop 20, when positioned within the RF coil 600 as described above, generate a secondary magnetic field *̅B̅*̅₂ perpendicular to *̅B̅*̅₁, in particular in the x direction.

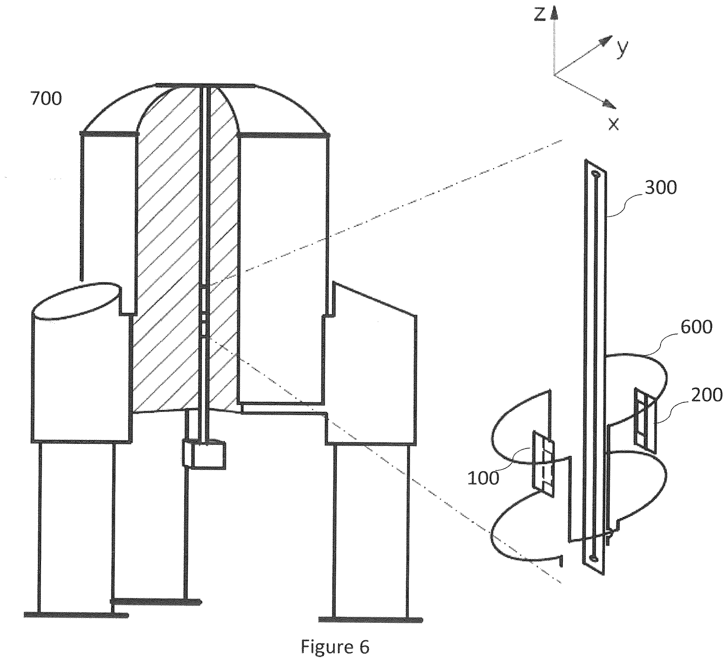

Another perspective on the spatial relation between the device and the RF coil 600 is given by **Figure 6****,** which shows a schematic representation of the positions of the PCBs 100, 200 and the sample holder 300 within an NMR spectrometer 700. The NMR spectrometer 700 comprises a bore in which the RF coil 600 is located and the device is positioned between the two sectors of the RF coil 600 so that at least part of the sample in the channel 350 and the two conductive loops 10, 20 are in correspondence of the RF coil 600.

The NMR spectrometer 700 further comprises a magnet that generates a static magnetic field *̅B̅*̅₀, e.g. a non-permanent magnet such as a superconductive solenoid coil. **Figure 7** shows a schematic representation of the arrangement of the conductive loops 10, 20 with respect to the RF coil 600 generating the oscillating magnetic field and the solenoid coil 750 generating the static magnetic field. The straight portions 12, 22 are shown as bands just in order to highlight them and the representation bears no relation to the actual width of a straight portion with respect to the rest of the loop.

The RF saddle coil 600 and the solenoid coil 750 are each configured to be connected to a respective power supply. The current circulating in the solenoid coil 750 generates a static magnetic field *̅B̅*̅₀, in the z direction while the current circulating in the RF saddle coil generates an oscillating magnetic field *̅B̅*̅₁ in the *y* direction. The device, when placed within the RF coil 600 so that the conductive loops 10, 20 are immersed in the oscillating magnetic field, generates the secondary magnetic field *̅B̅*̅₂. The operating principle of the device will be explained also with reference to **Figure 8**, which shows only the conductive loops and the magnetic fields' representations.

The device functions merely in virtue of its structure, specifically the relative position of the first conductive loop 10 and the second conductive loop 20, and its orientation with respect to the oscillating magnetic field. Indeed, since the oscillating magnetic field is perpendicular to the planes defined by the conductive loops, an electric current flowing in the loop is induced. The direction of the current is determined by Lenz's law and the current induced in the first straight portion 12 has opposite direction with respect to the current induced in the second straight portion 22. This is due to the fact that the remaining portion of the first conductive loop 10 and the remaining portion of the second conductive loop 20 are on opposite sides.

In turn, the current flowing in each straight portion produces an induced magnetic field, which is concentric with respect to the straight portion. In the space between the PCBs, the components of the magnetic field induced by the first straight portion 12 and of the magnetic field induced by the second straight portion 22 along the x direction superimpose constructively and create the secondary magnetic field. The secondary magnetic field is perpendicular to both the oscillating magnetic field and the static magnetic field. Further, the secondary magnetic field *̅B̅*̅₂ has a greater intensity than the oscillating magnetic field *̅B̅*̅₁, at least in the region of the channel 350 interposed between the straight portions.

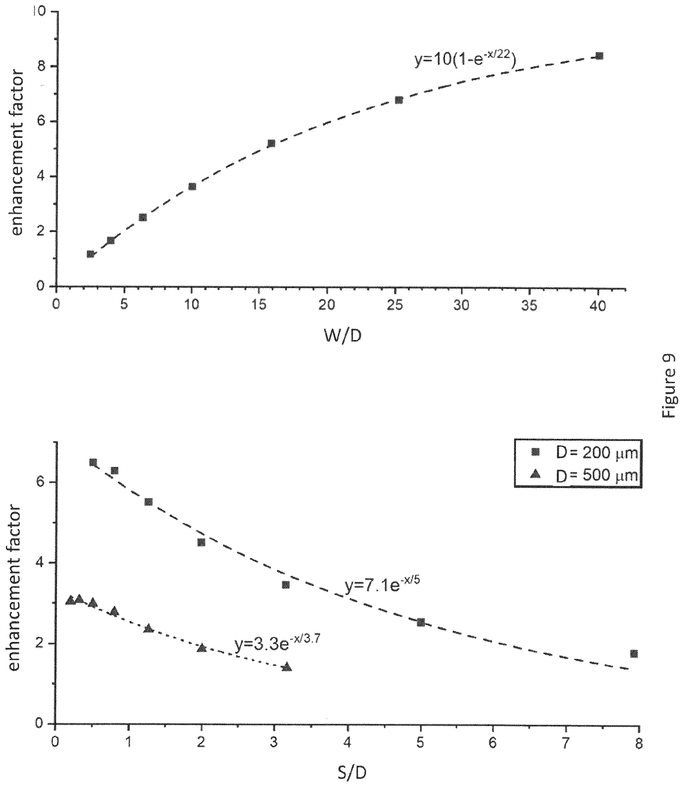

The ratio |*̅B̅*̅₂|/|*̅B̅*̅₁| (also called enhancement factor) is affected by various parameters of the device. In particular, the relevant parameters that should be tuned to maximize the enhancement factor are the width of the loop *W,* the width of the straight portions *S,* the distance between the straight portions *D* and the width of the remaining portions of the conductive loops *R.* Exemplary absolute values for these parameters have already been provided above. Constraints on ratios between these parameters will be discussed below with reference to Figure 9.

**Figure 9** shows two plots about the dependence of the enhancement factor on the parameters of the device. In particular, the upper plot shows the enhancement factor as a function of the ratio *W*/*D.* It can be seen that the enhancement factor increases as the ratio *W*/*D* increases. Accordingly, W should be maximised and/or *D* should be minimised, considering that W cannot exceed the radius of the RF coil and *D* cannot be less than the thickness of the sample to be analysed. If *D* is indeed the thickness of the sample (e.g. the height of the channel 350), *W* can exemplarily be chosen to be at least 10 times *D.* Further, in this example, W has to be at least 2 times *D* for the enhancement factor to be greater than 1.

The lower plot of Figure 9 shows the enhancement factor as a function of the ratio *S*/*D,* for two fixed values of *D,* namely 200 µm and 500 µm. It can be seen that the enhancement factor is generally higher when *D* is lower, i.e. 200 µm, and that it decreases with increasing *S.* Accordingly, *S* can exemplarily be chosen to be equal to or less than *D.*

Further, the enhancement factor increases with increasing *R.* This means that while the width of the straight portions should be minimized, the width of the remaining portions should be maximized. Exemplarily, *R* can be chosen to be at least 3 times *S.*

## Claims

1. A device configured to be inserted in an NMR spectrometer for analysing a sample, the device comprising:
a first conductive loop (10) comprising a first straight portion (12); and
a second conductive loop (20) comprising a second straight portion (22);
wherein each conductive loop (10, 20) is formed as a strip whose extremities coincide with each other to define an enclosure and wherein the first conductive loop (10) and the second conductive loop (20) are arranged such that:
a first plane containing the first conductive loop (10) is substantially parallel to a second plane containing the second conductive loop (20), wherein a space between the first plane and the second plane is a middle space;
the first straight portion (12) is substantially parallel to the second straight portion (22);
a third plane containing the first straight portion (12) and the second straight portion (22) is substantially perpendicular to the first and second planes, wherein the third plane defines a first half-space and a second half-space and wherein the intersection between the third plane and the first plane defines a first direction;
a projection of the second straight portion (22) on the first direction overlaps at least partly with the first straight portion (12);
the first conductive loop (10) is located in the first half-space and the second conductive loop (20) is located in the second half-space;
the middle space is adapted to receive at least part of the sample at a position between the first straight portion (12) and the second straight portion (22).

2. The device of claim 1, wherein the length of the first straight portion (12) and the length of the second straight portion (22) are substantially identical and a projection of the second straight portion (22) on the first direction overlaps substantially completely with the first straight portion (12).

3. The device of claim 1 or 2, wherein:
each of the first and second conductive loops (10, 20) has a rectangular shape having a width and a length, the length being greater than the width; and
each of the first and second straight portions (12, 22) represents the length.

4. The device of claim 3, wherein a ratio between:
- the arithmetic mean (W) of the width of the first conductive loop (12) and the width of the second conductive loop (22) and
- a distance (D) between the first straight portion (12) and the second straight portion (22)
is greater than or equal to 5, optionally greater than or equal to 10, further optionally greater than or equal to 20.

5. The device of any one of claims 1 to 4, wherein:
a ratio between a width (S) of the first straight portion (12) and a distance (D) between the first straight portion (12) and the second straight portion (22) is lower than or equal to 2, optionally lower than or equal to 1; and
a ratio between a width (S) of the second straight portion (22) and a distance between the first straight portion (12) and the second straight portion (22) is lower than or equal to 2, optionally lower than or equal to 1.

6. The device of any one of claims 1 to 5, wherein:
the first conductive loop (10) further comprises a first remaining portion and the second conductive loop (20) further comprises a second remaining portion; and
for each conductive loop a ratio between a width (R) of the remaining portion and a width of the straight portion (S) is greater than or equal to 2, optionally greater than or equal to 3.

7. The device of any one of claims 1 to 6, wherein the first conductive loop (10) is formed on a first printed circuit board (100) and the second conductive loop (20) is formed on a second printed circuit board (200).

8. The device of any one of claims 1 to 7, further comprising a sample holder (300) configured to hold the sample.

9. The device of claim 8, wherein the sample holder (300) comprises a microfluidic channel (350).

10. The device of any one of claims 1 to 9, further comprising a first pair of conductive extensions (14, 16) and a second pair of conductive extensions (24, 26), wherein:
the intersection between the third plane and the second plane defines a second direction;
the first pair of conductive extensions (14, 16) is arranged along the first direction and is conductively connected to the first straight portion (12);
the second pair of conductive extensions (24, 26) is arranged along the second direction and is conductively connected to the second straight portion (22);
the first pair of conductive extensions (14, 16) comprises a first upper conductive extension (14) and a first lower conductive extension (16);
the first upper conductive extension (14) and the first lower conductive extension (16) are on opposite sides of the first straight portion (12);
the second pair of conductive extensions (24, 26) comprises a second upper conductive extension (24) and a second lower conductive extension (26);
the second upper conductive extension (24) and the second lower conductive extension (26) are on opposite sides of the second straight portion (22).

11. The device of any one of claims 1 to 10, further comprising a first support component (400) and a second support component (500), wherein:
the first support component (400) is located on a side of the first conductive loop (10) opposite the second conductive loop (20); and
the second support component (400) is located on a side of the second conductive loop (20) opposite the first conductive loop (10).

12. The device of claim 11, wherein the first support component (400) comprises a first primary recess (410) configured to accommodate the first conductive loop (10) and the second support component (500) comprises a second primary recess (510) configured to accommodate the second conductive loop (20).

13. The device of claim 12, wherein the first support component (400) further comprises a first secondary recess (420) configured to accommodate the sample or the second support component (500) comprises a second secondary recess configured to accommodate the sample.

14. A system comprising:
a device according to any one of claims 1 to 13; and
an NMR spectrometer (700) comprising a radio frequency coil (600) configured to generate an oscillating magnetic field;
wherein:
the device is positioned within the radio frequency coil (600) such that the oscillating magnetic field is perpendicular to the first and second planes; and
the device is configured to generate a secondary magnetic field perpendicular to the oscillating magnetic field and perpendicular to the first and second straight portions (12, 22), wherein the intensity of the secondary magnetic field is greater than the intensity of the oscillating magnetic field.

15. A method of performing an NMR spectroscopic analysis, the method comprising:
placing a device according to any one of claims 1 to 13 within a radio frequency coil (600) of an NMR spectrometer (700);
placing at least part of a sample at the position between the first straight portion (12) and the second straight portion (22);
providing electrical current to the radio frequency coil (600);
generating, by the radio frequency coil (600), an oscillating magnetic field;
generating, by the device, a secondary magnetic field perpendicular to the oscillating magnetic field and perpendicular to the first and second straight portions, wherein the intensity of the secondary magnetic field is greater than the intensity of the oscillating magnetic field.

## Patentansprüche

1. Vorrichtung, die konfiguriert ist, in ein NMR-Spektrometer zum Analysieren einer Probe eingesetzt zu werden, wobei die Vorrichtung umfasst:
eine erste leitfähige Schleife bzw. Leiterschleife (10), die einen ersten geraden Abschnitt (12) umfasst; und
eine zweite leitfähige Schleife bzw. Leiterschleife (20), die einen zweiten geraden Abschnitt (22) umfasst;
wobei jede Leiterschleife (10,20) als ein Streifen gebildetist, deren bzw. dessen Enden miteinander zusammentreffen, um eine Umschließung zu definieren, und wobei die erste Leiterschleife (10) und die zweite Leiterschleife (20) derart angeordnet sind, dass:
eine erste Ebene, die die erste Leiterschleife (10) enthält, im Wesentlichen parallel zu einer zweiten Ebene ist, die die zweite Leiterschleife (20) enthält, wobei ein Raum zwischen derersten Ebene und derzweiten Ebeneein mittlerer Raum bzw. Zwischenraum ist;
der erste gerade Abschnitt (12) im Wesentlichen parallel zu dem zweiten geraden Abschnitt (22) ist;
eine dritte Ebene, die den ersten geraden Abschnitt (12) und den zweiten geraden Abschnitt(22) enthält, im Wesentlichen senkrechtzu der ersten und der zweiten Ebene ist, wobei die dritte Ebene einen ersten Halbraum und einen zweiten Halbraum definiert und wobei der Schnittpunkt zwischen der dritten Ebene und der ersten Ebene eine erste Richtung definiert;
eine Projektion bzw. ein Vorsprung des zweiten geraden Abschnitts (22) auf die erste Richtung zumindest teilweise mit dem ersten geraden Abschnitt (12) überlappt;
sich die erste Leiterschleife (10) in dem ersten Halbraum befindet und sich die zweite Leiterschleife (20) in dem zweiten Halbraum befindet;
der mittlere Raum angepasst ist, zumindest einen Teil der Probe an einer Position zwischen dem ersten geraden Abschnitt(12) und dem zweiten geraden Abschnitt (22) aufzunehmen.

2. Vorrichtung nach Anspruch 1, wobei die Länge des ersten geraden Abschnitts (12) und die Länge des zweiten geraden Abschnitts (22) im Wesentlichen identisch sind und eine Projektion bzw. ein Vorsprung des zweiten geraden Abschnitts (22) auf die erste Richtung im Wesentlichen vollständig mit dem ersten geraden Abschnitt (12) überlappt.

3. Vorrichtung nach Anspruch 1 oder 2, wobei:
jede der ersten und zweiten Leiterschleife (10, 20) eine rechteckige Form mit einer Breite und einer Länge aufweist, wobei die Länge größer ist als die Breite; und
jeder des ersten und zweiten geraden Abschnitts (12, 22) die Länge darstellt.

4. Vorrichtung nach Anspruch 3, wobei ein Verhältnis zwischen:
- dem arithmetischen Mittel (W) der Breite der ersten Leiterschleife (12) und der Breite der zweiten Leiterschleife (22) und
- einem Abstand (D) zwischen dem ersten geraden Abschnitt (12) und dem zweiten geraden Abschnitt (22)
größer oder gleich 5, optional größer oder gleich 10, ferner optional größer oder gleich 20 ist.

5. Vorrichtung nach einem der Ansprüche 1 bis 4, wobei:
ein Verhältniszwischen einer Breite (S) des ersten geraden Abschnitts(12) und einem Abstand (D) zwischen dem ersten geraden Abschnitt (12) und dem zweiten geraden Abschnitt(22) kleineroder gleich 2, optional kleinerodergleich 1 ist; und
ein Verhältnis zwischen einer Breite (S) des zweiten geraden Abschnitts (22) und einem Abstand zwischen dem ersten geraden Abschnitt (12) und dem zweiten geraden Abschnitt(22) kleiner oder gleich 2, optional kleinerodergleich 1 ist.

6. Vorrichtung nach einem der Ansprüche 1 bis 5, wobei:
die erste Leiterschleife (10) ferner einen ersten verbleibenden Abschnitt umfasst und die zweite Leiterschleife (20) ferner einen zweiten verbleibenden Abschnitt umfasst; und
für jede Leiterschleife ein Verhältnis zwischen einer Breite (R) des verbleibenden Abschnitts und einer Breite des geraden Abschnitts (S) größer oder gleich 2, optional größer oder gleich 3 ist.

7. Vorrichtung nach einem der Ansprüche 1 bis 6, wobei die erste Leiterschleife (10) auf einer ersten Leiterplatte (100) gebildet ist und die zweite Leiterschleife (20) auf einer zweiten Leiterplatte (200) gebildet ist.

8. Vorrichtung nach einem der Ansprüche 1 bis 7, ferner umfassend einen Probenhalter (300), der konfiguriert ist, die Probe zu halten.

9. Vorrichtung nach Anspruch 8, wobei der Probenhalter(300) einen Mikrofluidik-Kanal (350) umfasst.

10. Vorrichtung nach einem der Ansprüche 1 bis 9, ferner umfassend ein erstes Paar leitfähiger Verlängerungen bzw. Leiterverlängerungen (14, 16) und ein zweites Paar leitfähiger Verlängerungen bzw. Leiterverlängerungen (24, 26), wobei:
der Schnittpunktzwischen derdritten Ebene und der zweiten Ebeneeinezweite Richtung definiert;
das erste Paar Leiterverlängerungen (14, 16) entlang der ersten Richtung angeordnet und leitfähig mit dem ersten geraden Abschnitt (12) verbunden ist; das zweite Paar Leiterverlängerungen (24, 26) entlang der zweiten Richtung angeordnetundleitfähigmitdem zweiten geraden Abschnitt(22) verbunden ist; das erste Paar Leiterverlängerungen (14, 16) eine erste obere leitfähige Verlängerung bzw. Leiterverlängerung (14) und eine erste untere leitfähige Verlängerung bzw. Leiterverlängerung (16) umfasst;
sich die erste obere Leiterverlängerung (14) und die erste untere Leiterverlängerung (16) auf gegenüberliegenden bzw. entgegengesetzten Seiten des ersten geraden Abschnitts (12) befinden;
das zweite Paar Leiterverlängerungen (24, 26) eine zweite obere leitfähige Verlängerung bzw. Leiterverlängerung (24) und eine zweite untere leitfähige Verlängerung bzw. Leiterverlängerung (26) umfasst;
sich die zweite obere Leiterverlängerung (24) und die zweite untere Leiterverlängerung (26) auf gegenüberliegenden bzw. entgegengesetzten Seiten des zweiten geraden Abschnitts (22) befinden.

11. Vorrichtung nach einem der Ansprüche 1 bis 10, ferner umfassend eine erste Stütz- bzw. Trägerkomponente (400) und eine zweite Stütz- bzw. Trägerkomponente (500), wobei:
sich die erste Stützkomponente (400) auf einer Seite der ersten Leiterschleife (10) gegenüberliegend bzw. entgegengesetzt zu der zweiten Leiterschleife (20) befindet; und
sich die zweite Stützkomponente (400) auf einerSeite der zweiten Leitersch leife (20) gegenüberliegend bzw. entgegengesetzt zu der ersten Leiterschleife (10) befindet.

12. Vorrichtung nach Anspruch 11, wobei die erste Stützkomponente (400) eine erste primäre Aussparung (410) umfasst, die konfiguriert ist, die erste Leiterschleife (10) aufzunehmen, und die zweite Stützkomponente (500) eine zweite primäre Aussparung (510) umfasst, die konfiguriert ist, die zweite Leiterschleife (20) aufzunehmen.

13. Vorrichtung nach Anspruch 12, wobei die erste Stützkomponente (400) ferner eine erste sekundäre Aussparung (420) umfasst, die konfiguriert ist, die Probe aufzunehmen, oder die zweite Stützkomponente (500) eine zweite sekundäre Aussparung umfasst, die konfiguriert ist, die Probe aufzunehmen.

14. System, umfassend:
eine Vorrichtung nach einem der Ansprüche 1 bis 13; und
ein NMR-Spektrometer (700), das eine Hochfrequenzspule (600) umfasst, die konfiguriert ist, ein oszillierendes Magnetfeld zu erzeugen;
wobei:
die Vorrichtung innerhalb der Hochfrequenzspule (600) so positioniert ist, dass das oszillierende Magnetfeld senkrecht zu der ersten und zweiten Ebene ist; und
die Vorrichtung konfiguriert ist, ein sekundäres Magnetfeld senkrecht zu dem oszillierenden Magnetfeld und senkrecht zu dem ersten und zweiten geraden Abschnitt (12, 22) zu erzeugen, wobei die Intensität des sekundären Magnetfelds größer ist als die Intensität des oszillierenden Magnetfelds.

15. Verfahren zum Durchführen einer NMR-spektroskopischen Analyse, wobei das Verfahren umfasst:
Platzieren einerVorrichtung nach einem derAnsprüche 1 bis 13 innerhalb einer Hochfrequenzspule (600) eines NMR-Spektrometers (700);
Platzieren zumindest eines Teils einer Probe an der Position zwischen dem ersten geraden Abschnitt (12) und dem zweiten geraden Abschnitt (22);
Versorgen der Hochfrequenzspule (600) mit elektrischem Strom;
Erzeugen, durch die Hochfrequenzspule (600), eines oszillierenden Magnetfelds;
Erzeugen, durch die Vorrichtung, eines sekundären Magnetfelds senkrechtzu dem oszillierenden Magnetfeld und senkrecht zu dem ersten und zweiten geraden Abschnitt, wobei die Intensität des sekundären Magnetfelds größer ist als die Intensität des oszillierenden Magnetfelds.

## Revendications

1. Dispositif configuré pour être inséré dans un spectromètre RMN pour analyser un échantillon, le dispositif comprenant :
une première boucle conductrice (10) comprenant une première portion droite (12) ; et
une seconde boucle conductrice (20) comprenant une seconde portion droite (22) ;
dans lequel chaque boucle conductrice (10, 20) est formée en tant que bande dont les extrémités coïncident l'une avec l'autre pour définir une enceinte, et dans lequel la première boucle conductrice (10) et la seconde boucle conductrice (20) sont agencées de sorte que :
un premier plan contenant la première boucle conductrice (10) est essentiellement parallèle à un deuxième plan contenant la seconde boucle conductrice (20), dans lequel un espace entre le premier plan et le deuxième plan est un espace central ;
la première portion droite (12) est essentiellement parallèle à la seconde portion droite (22) ;
un troisième plan contenant la première portion droite (12) et la seconde portion droite (22) est essentiellement perpendiculaire aux premier et second plans, dans lequel le troisième plan définit un premier demi-espace et un second demi-espace, et dans lequel l'intersection entre le troisième plan et le premier plan définit une première direction ;
une projection de la seconde portion droite (22) sur la première direction chevauche au moins partiellement la première portion droite (12) ;
la première boucle conductrice (10) est située dans le premier demi-espace et la seconde boucle conductrice (20) est située dans le second demi-espace ;
l'espace central est adapté à recevoir au moins une partie de l'échantillon à une position entre la première portion droite (12) et la seconde portion droite (22).

2. Dispositif selon la revendication 1, dans lequel la longueur de la première portion droite (12) et la longueur de la seconde portion droite (22) sont essentiellement identiques, et une projection de la seconde portion droite (22) sur la première direction chevauche essentiellement complètement la première portion droite (12).

3. Dispositif selon la revendication 1 ou 2, dans lequel :
chacune des première et seconde boucles conductrices (10, 20) a une forme rectangulaire ayant une largeur et une longueur, la longueur étant supérieure à la largeur ; et
chacune des première et seconde portions droites (12, 22) représente la longueur.

4. Dispositif selon la revendication 3, dans lequel un rapport entre :
- la moyenne arithmétique (W) de la largeur de la première boucle conductrice (12) et la largeur de la seconde boucle conductrice (22), et
- une distance (D) entre la première portion droite (12) et la seconde portion droite (22)
est supérieur ou égal à 5, en option supérieur ou égal à 10, davantage en option supérieur ou égal à 20.

5. Dispositif selon l'une quelconque des revendications 1 à 4, dans lequel :
un rapport entre une largeur (S) de la première portion droite (12) et une distance (D) entre la première portion droite (12) et la seconde portion droite (22) est inférieur ou égal à 2, en option inférieur ou égal à 1 ; et
un rapport entre une largeur (S) de la seconde portion droite (22) et une distance entre la première portion droite (12) et la seconde portion droite (22) est inférieur ou égal à 2, en option inférieur ou égal à 1.

6. Dispositif selon l'une quelconque des revendications 1 à 5, dans lequel :
la première boucle conductrice (10) comprend en outre une première portion restante et la seconde boucle conductrice (20) comprend en outre une seconde portion restante ; et
pour chaque boucle conductrice, un rapport entre une largeur (R) de la portion restante et une largeur de la portion droite (S) est supérieur ou égal à 2, en option supérieur ou égal à 3.

7. Dispositif selon l'une quelconque des revendications 1 à 6, dans lequel la première boucle conductrice (10) est formée sur une première carte de circuit imprimé (100) et la seconde boucle conductrice (20) est formée sur une seconde carte de circuit imprimé (200).

8. Dispositif selon l'une quelconque des revendications 1 à 7, comprenant en outre un porte-éprouvette (300) configuré pour contenir l'échantillon.

9. Dispositif selon la revendication 8, dans lequel le porte-éprouvette (300) comprend un canal microfluidique (350).

10. Dispositif selon l'une quelconque des revendications 1 à 9, comprenant en outre une première paire de rallonges conductrices (14, 16) et une seconde paire de rallonges conductrices (24, 26), dans lequel :
l'intersection entre le troisième plan et le deuxième plan définit une seconde direction ;
la première paire de rallonges conductrices (14, 16) est agencée le long de la première direction et est connectée de manière conductrice à la première portion droite (12) :
la seconde paire de rallonges conductrices (24, 26) est agencée le long de la seconde direction et est connectée de manière conductrice à la seconde portion droite (22) :
la première paire de rallonges conductrices (14, 16) comprend une première rallonge conductrice supérieure (14) et une première rallonge conductrice inférieure (16) ;
la première rallonge conductrice supérieure (14) et la première rallonge conductrice inférieure (16) sont sur des côtés opposés de la première portion droite (12) ;
la seconde paire de rallonges conductrices (24, 26) comprend une seconde rallonge conductrice supérieure (24) et une seconde rallonge conductrice inférieure (26) ;
la seconde rallonge conductrice supérieure (24) et la seconde rallonge conductrice inférieure (26) sont sur des côtés opposés de la seconde portion droite (22).

11. Dispositif selon l'une quelconque des revendications 1 à 10, comprenant en outre un premier composant de support (400) et un second composant de support (500), dans lequel :
le premier composant de support (400) est situé sur un côté de la première boucle conductrice (10) à l'opposé de la seconde boucle conductrice (20) ; et
le second composant de support (400) est situé sur un côté de la seconde boucle conductrice (20) à l'opposé de la première boucle conductrice (10).

12. Dispositif selon la revendication 11, dans lequel le premier composant de support (400) comprend un premier retrait primaire (410) configuré pour héberger la première boucle conductrice (10) et le second composant de support (500) comprend un second retrait primaire (510) configuré pour héberger la seconde boucle conductrice (20).

13. Dispositif selon la revendication 12, dans lequel le premier composant de support (400) comprend en outre un premier retrait secondaire (420) configuré pour héberger l'échantillon ou le second composant de support (500) comprend un second retrait secondaire configuré pour héberger l'échantillon.

14. Système comprenant :
un dispositif selon l'une quelconque des revendications 1 à 13 ; et
un spectromètre RMN (700) comprenant une bobine à radiofréquence (600) configurée pour générer un champ magnétique oscillant ;
dans lequel :
le dispositif est positionné au sein de la bobine à radiofréquence (600) de sorte que le champ magnétique oscillant est perpendiculaire aux premier et deuxième plans ; et
le dispositif est configuré pour générer un champ magnétique secondaire perpendiculaire au champ magnétique oscillant et perpendiculaire aux première et seconde portions droites (12, 22), dans lequel l'intensité du champ magnétique secondaire est supérieure à l'intensité du champ magnétique oscillant.

15. Procédé de réalisation d'une analyse spectroscopique RMN, le procédé comprenant :
placer un dispositif selon l'une quelconque des revendications 1 à 13 au sein d'une bobine à radiofréquence (600) d'un spectromètre RMN (700) ;
placer au moins une partie d'un échantillon à la position entre la première portion droite (12) et la seconde portion droite (22) ;
fournir du courant électrique à la bobine à radiofréquence (600) ;
générer, par la bobine à radiofréquence (600), un champ magnétique oscillant ;
générer, par le dispositif, un champ magnétique secondaire perpendiculaire au champ magnétique oscillant et perpendiculaire aux première et seconde portions droites, dans lequel l'intensité du champ magnétique secondaire est supérieure à l'intensité du champ magnétique oscillant.
